# EUROPEAN PATENT APPLICATION

(11) **EP 4 548 894 A1**
(43) Date of publication of application: **07.05.2025**
(21) Application number: 23830861.3
(22) Date of filing: 15.05.2023
(51) Int. Cl.: A61G 5/00, A61G 5/12

(54) **WHEELCHAIR SIMULATOR**

(30) Priority: 28.06.2022 JP 2022103704
(71) Applicant: Chiba Institute of Technology, Narashino-shi, Chiba 275-0016 (JP)
(72) Inventor: YAMATO, Hideaki, Narashino-shi, Chiba 275-0016 (JP); HOKOI, Takaaki, Narashino-shi, Chiba 275-0016 (JP); OGIHARA, Kazuki, Narashino-shi, Chiba 275-0016 (JP); TODA, Kengo, Narashino-shi, Chiba 275-0016 (JP); KODACHI, Takashi, Narashino-shi, Chiba 275-0016 (JP); MATSUZAWA, Takaaki, Narashino-shi, Chiba 275-0016 (JP); FURUTA, Takayuki, Narashino-shi, Chiba 275-0016 (JP)
(74) Representative: Zimmermann, Tankred Klaus
(86) International application number: PCT/JP2023/018097
(87) International publication number: WO 2024/004409

(57) **Abstract**

There is provided a wheelchair simulator capable of manufacturing a wheelchair according to user's preference without complicating a structure of the wheelchair. A wheelchair simulator (1) includes a wheelchair (10) including a chair having a seat and wheels attached to the chair, a display unit (30) that displays information, and a control unit (50) that controls the display unit (30). The wheelchair (10) includes a parameter changing unit (4) that changes a parameter related to a structure of the wheelchair (10). The control unit (50) includes a display controller (501) that causes the display unit (30) to display a parameter changed via the parameter changing unit (4).

## Description

### TECHNICAL FIELD

The present invention relates to a wheelchair simulator.

### BACKGROUND ART

Conventionally, a chair having a seat and a wheelchair having wheels attached to the chair and assisting movement of a user are known. The manufacturer of such a wheelchair measures in advance the height of the seat, the angle of the backrest of the chair, and the like according to the preference of the user, the dimensions of the body, and the like, and manufactures the wheelchair according to the preference of the user, the dimensions of the body, and the like based on the measurement result.

On the other hand, for example, the wheelchair described in Patent Literature 1 is configured to be able to selectively determine the height of the seat, the angle of the backrest of the chair, and the like after manufacturing the wheelchair.

### CITATION LIST

### PATENT LITERATURE

Patent Literature 1: JP-T-2002-535107

### SUMMARY OF INVENTION

### PROBLEMS TO BE SOLVED BY INVENTION

However, since the wheelchair described in Patent Literature 1 can selectively determine the angle of the backrest of the chair and the like, there is a problem that the structure becomes complicated.

An object of the present invention is to provide a wheelchair simulator capable of manufacturing a wheelchair according to user's preference without complicating the structure of the wheelchair.

### SOLUTION TO PROBLEMS

A wheelchair simulator according to the present invention includes a wheelchair including a chair having a seat and wheels attached to the chair, a display unit that displays information, and a control unit that controls the display unit. The wheelchair includes a parameter changing unit that changes a parameter related to a structure of the wheelchair. The control unit includes a display controller that causes the display unit to display the parameter changed via the parameter changing unit.

According to such a configuration, since the control unit includes the display controller that causes the display unit to display the parameter changed via the parameter changing unit, the user can change the parameter (height and angle of seat, width, angle, and load of wheel, and the like) related to the structure of the wheelchair according to the preference, and it is possible to confirm the parameter on the display unit. Therefore, the wheelchair simulator can perform a simulation for manufacturing the wheelchair according to the preference of the user, and the wheelchair manufacturer can manufacture the wheelchair according to the preference of the user without complicating the structure of the wheelchair based on the result of the simulation.

In the present invention, the parameter changing unit preferably includes a seat elevating mechanism that elevates the seat.

According to such a configuration, since the parameter changing unit includes the seat elevating mechanism that raises and lowers the seat, it is possible to change the height of the seat with respect to the wheel by raising and lowering the seat, and it is possible to appropriately perform the simulation. In addition, since the parameter changing unit can lower the seat, the user can easily transfer from the wheelchair on which the user is riding to the seat of the wheelchair in the wheelchair simulator as compared with the case in which the parameter changing unit is configured to change the height of the wheel with respect to the seat.

In the present invention, the seat elevating mechanism preferably supports a rear end of the seat.

According to such a configuration, since the seat elevating mechanism supports the rear end of the seat, it is unnecessary to arrange a member that supports the seat on the front side of the seat, and it is possible to simplify the structure of the wheelchair. In addition, since it is unnecessary to arrange the member that supports the seat on the front side of the seat, the user can easily transfer from the wheelchair on which the user is riding to the seat of the wheelchair in the wheelchair simulator.

In the present invention, preferably, the wheelchair includes a footrest, and the parameter changing unit includes a footrest advance/retract mechanism that advances and retracts the position of the footrest forward and backward.

According to such a configuration, since the parameter changing unit includes the footrest advance/retract mechanism that advances and retracts the position of the footrest forward and backward, it is possible to appropriately change the position of the footrest, and it is possible to perform the simulation. In addition, in the case in which the member that supports the seat is unnecessary to be disposed on the front side of the seat, it is possible to retract the position of the footrest to the position immediately below the seat, and it is possible to perform the simulation of the sitting posture while the knee is bent and the lower leg is placed below the seat.

In the present invention, preferably, an operation unit that receives an operation input of a user is provided, the control unit includes a change controller that causes the parameter changing unit to change a parameter based on the operation input received via the operation unit, and the display controller causes the display unit to display the parameter changed by the change controller.

According to such a configuration, the control unit includes the change controller that causes the parameter changing unit to change the parameter based on the operation input received via the operation unit, and the display controller causes the display unit to display the parameter changed by the change controller. Therefore, the user can cause the control unit to change the parameter related to the structure of the wheelchair according to preference via the operation unit, and the user can confirm the parameter on the display unit. Therefore, the wheelchair simulator makes it possible to improve the convenience of the user.

In the present invention, the wheel is preferably configured to be separable into a plurality of parts and configured to be detachable from the chair.

According to such a configuration, since the wheel is configured to be separable into a plurality of parts and is configured to be detachable from the chair, it is possible to easily attach the wheel having a different diameter to the chair to change the diameter of the wheel.

In the present invention, preferably, the control unit includes a center-of-gravity measurement unit that measures the center of gravity on the seat, and the display controller causes the display unit to display the center of gravity on the seat measured by the center-of-gravity measurement unit.

According to such a configuration, since the display controller causes the display unit to display the center of gravity on the seat measured by the center-of-gravity measurement unit, the user can confirm the center of gravity on the seat by the display unit. Therefore, the wheelchair simulator makes it possible to suitably perform the simulation for manufacturing the wheelchair according to the preference of the user.

In the present invention, preferably, a base that supports the entire wheelchair is provided, the base includes a load sensor that detects a load applied to the base, and the center-of-gravity measurement unit measures the center of gravity on the seat based on the load applied to the base detected by the load sensor.

Here, since the load by the user of the wheelchair escapes to the wheel, the footrest, or the like, when the center of gravity on the seat is measured based on the load applied to the seat, the center-of-gravity measurement unit fails to accurately measure the center of gravity.

According to the present invention, since the center-of-gravity measurement unit measures the center of gravity on the seat based on the load applied to the base detected by the load sensor, it is possible to accurately measure the center of gravity.

### BRIEF DESCRIPTION OF DRAWINGS

Fig. 1 is an external perspective view showing a wheelchair of a wheelchair simulator according to an embodiment of the present invention.
Fig. 2 is a front view showing the wheelchair of the wheelchair simulator.
Fig. 3 is a left side view showing the wheelchair of the wheelchair simulator.
Fig. 4 is a plan view showing the wheelchair of the wheelchair simulator.
Fig. 5 is a left side view showing a seat of a chair.
Fig. 6 is a perspective view showing a seat elevating mechanism that elevates a seat of the chair.
Fig. 7 is a view showing a state in which the seat of the chair is lowered.
Fig. 8 is a view showing a state in which the seat of the chair is raised.
Fig. 9 is a view showing a state in which the seat of the chair is turned.
Fig. 10 is a left side view showing a backrest of the chair.
Fig. 11 is a perspective view showing a shape changing mechanism that changes a shape of the backrest of the chair.
Fig. 12 is a view showing a state in which a back support of the chair is lowered.
Fig. 13 is a view showing a state in which the back support of the chair is raised.
Fig. 14 is a view showing a state in which the back support of the chair is moved forward.
Fig. 15 is a view showing a state in which the back support of the chair is retracted.
Fig. 16 is a view showing a state in which the back support of the chair is turned.
Fig. 17 is a perspective view showing the shape changing mechanism that changes a shape of the backrest of the chair.
Fig. 18 is a view showing a state in which a lumbar support of the chair is moved forward.
Fig. 19 is a view showing a state in which the lumbar support of the chair is retracted.
Fig. 20 is a left side view showing a footrest of the chair.
Fig. 21 is a perspective view showing a footrest advance/retract mechanism that advances and retracts a position of the back footrest of the chair forward and backward.
Fig. 22 is a view showing a state in which the footrest of the chair is moved forward.
Fig. 23 is a view showing a state in which the footrest of the chair is raised.
Fig. 24 is a view showing a state in which the footrest of the chair is turned.
Fig. 25 is a perspective view showing wheels of the wheelchair.
Fig. 26 is a front view showing a normal position of the wheel of the wheelchair.
Fig. 27 is a left side view showing a normal position of the wheel of the wheelchair.
Fig. 28 is a view showing a wheel main body.
Fig. 29 is a view showing a state in which an attachment is removed from a wheel plate.
Fig. 30 is an enlarged view showing a connecting part between the flange of the wheel plate and the attachment as viewed from the wheel support body side.
Fig. 31 is an enlarged view showing the connecting part between the flange of the wheel plate and the attachment as viewed from the chair side.
Fig. 32 is a view showing a cross section of the wheel main body and the wheel support body.
Fig. 33 is a view showing a state in which the wheel support body is turned.
Fig. 34 is a view showing a state in which the wheel support body is moved.
Fig. 35 is a view showing a state in which a wheel moving base is advanced.
Fig. 36 is a view showing a state in which the wheel moving base is retracted.
Fig. 37 is a view showing a cross section of a leg member of the base.
Fig. 38 is a schematic configuration diagram showing an overall configuration of the wheelchair simulator.

### DESCRIPTION OF EMBODIMENTS

In the following, an embodiment of the present invention will be described with reference to the drawings.

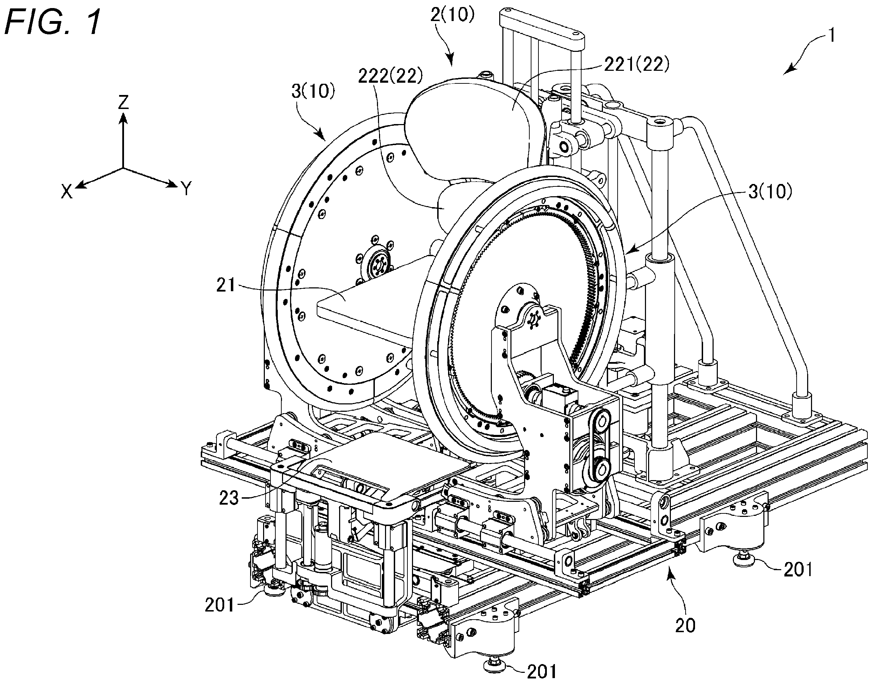

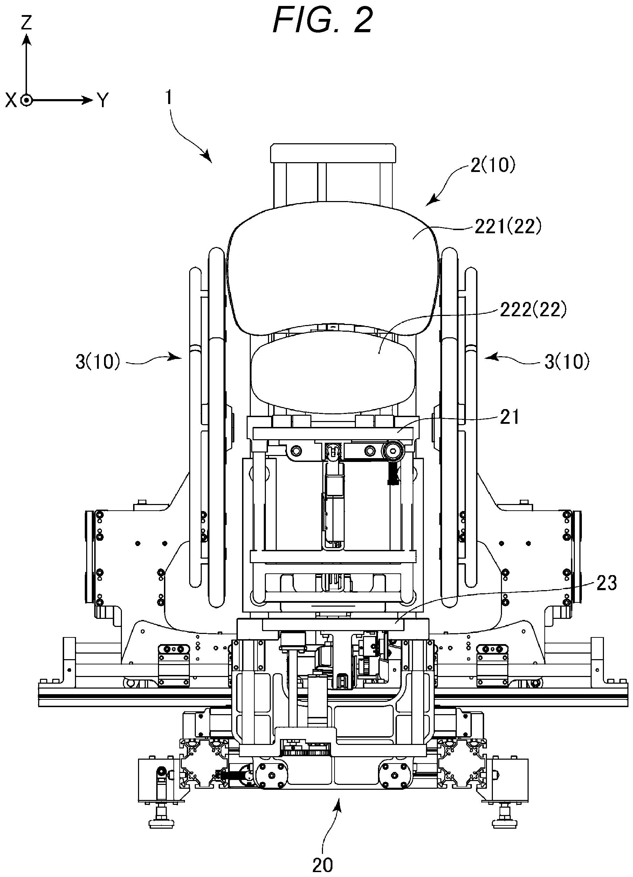

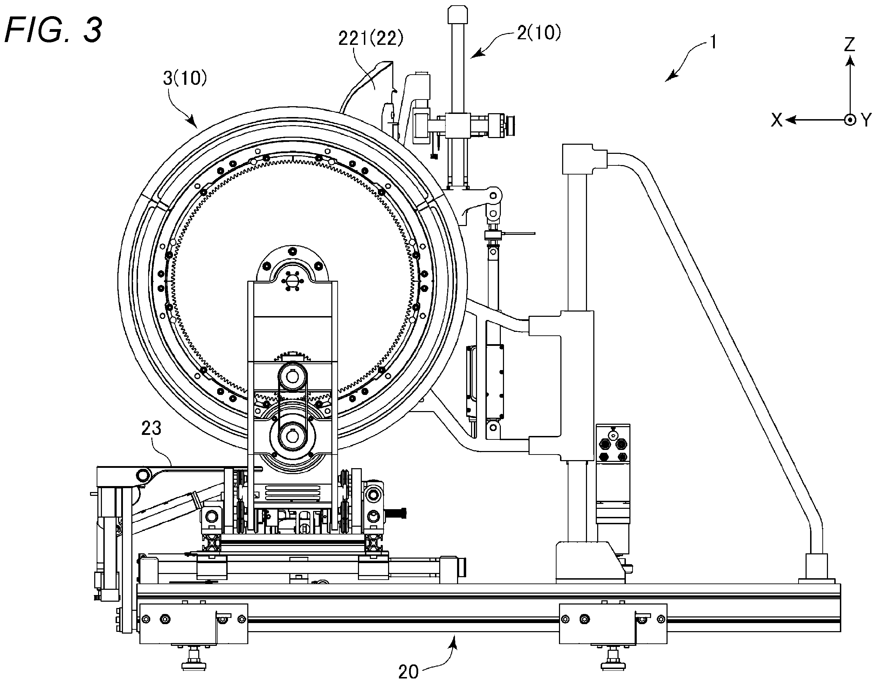

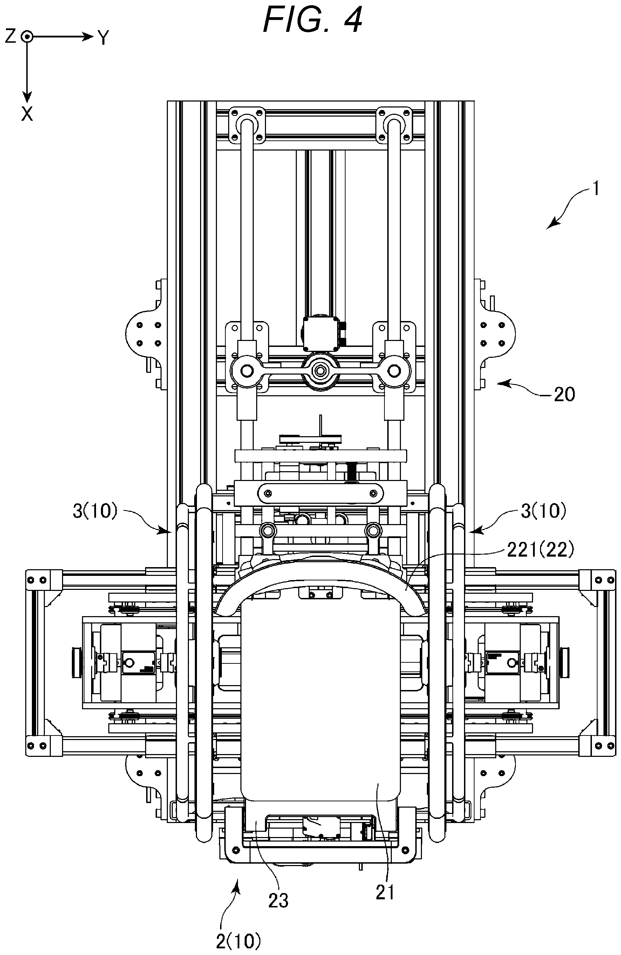

Fig. 1 is an external perspective view showing a wheelchair of a wheelchair simulator according to an embodiment of the present invention. Fig. 2 is a front view showing the wheelchair of the wheelchair simulator. Fig. 3 is a left side view showing the wheelchair of the wheelchair simulator. Fig. 4 is a plan view showing the wheelchair of the wheelchair simulator.

Note that in Figs. 1 to 4, a vertical upward direction is defined as a +Z axis direction, and two axes orthogonal to the Z axis are defined as X and Y axes. The same applies to the following drawings.

As shown in Figs. 1 to 4, the wheelchair simulator 1 includes a wheelchair 10 including a chair 2 on which a user sits and a pair of wheels 3 arranged side by side on the chair 2, and a base 20 that supports the entire wheelchair 10.

The chair 2 includes a seat 21 that is a part on which the user sits, a backrest 22 that is a part on which the user leans the user's back, and a footrest 23 that is a part on which the user places the user's foot.

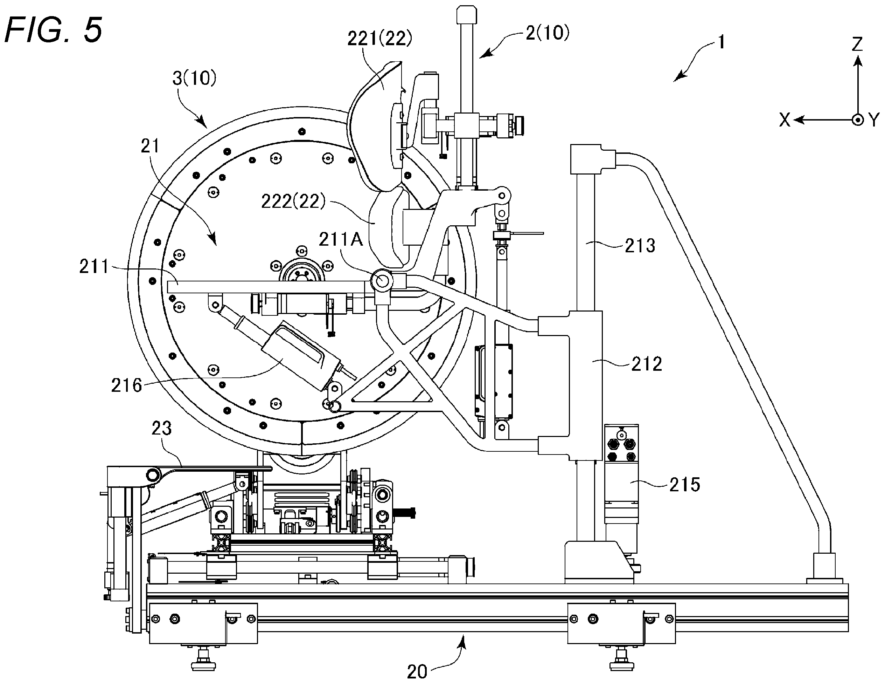

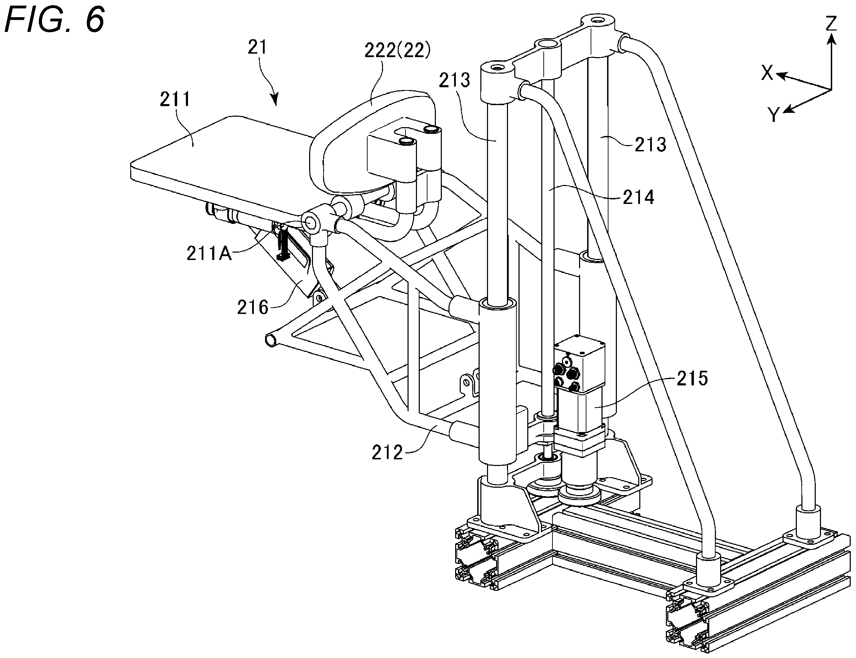

Fig. 5 is a left side view showing the seat of the chair. Specifically, Fig. 5 is a view showing a state in which the left wheel 3 is removed in the left side view of the wheelchair 10 in Fig. 3. Fig. 6 is a perspective view showing a seat elevating mechanism that raises and lowers the seat of the chair.

As shown in Figs. 5 and 6, the seat 21 includes a seat main body 211 that is a part on which a user sits, a support body 212 that supports an end of the seat main body 211 on the rear side (-X axis direction side), two shafts 213 that support the support body 212 so as to be movable up and down, a trapezoidal screw 214 (see Fig. 6) that is screwed with the support body 212 and attached between the two shafts 213, and a seat motor 215 that rotates the trapezoidal screw 214.

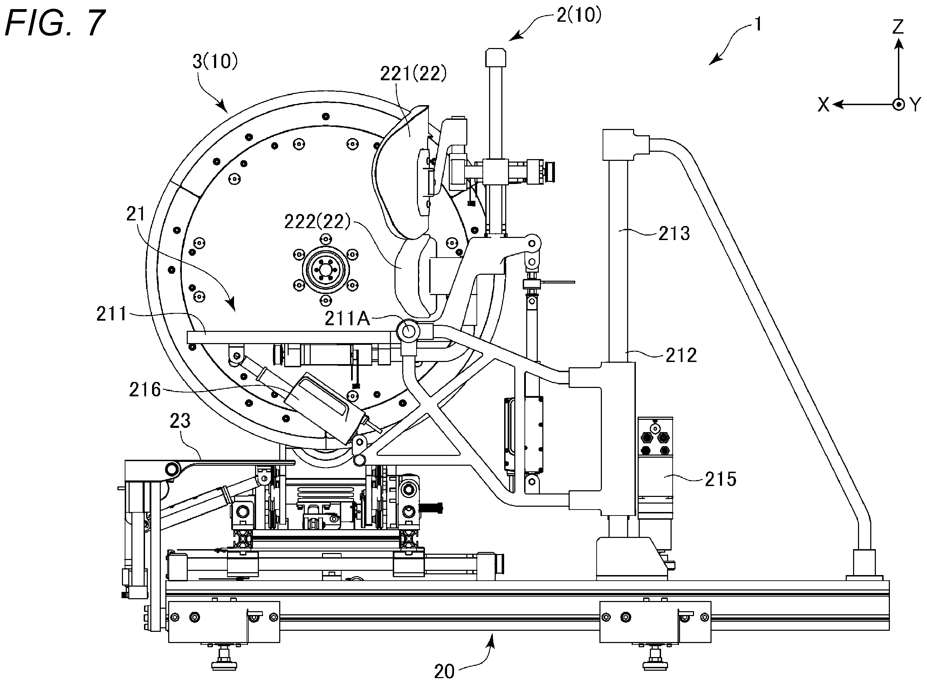

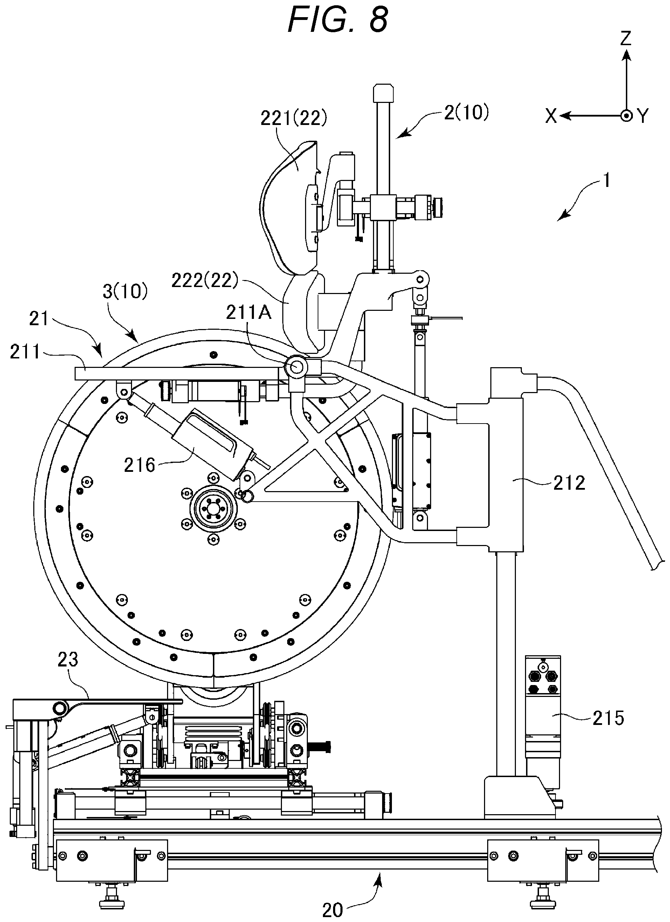

Fig. 7 is a view showing a state in which the seat of the chair is lowered. Fig. 8 is a view showing a state in which the seat of the chair is raised.

When the trapezoidal screw 214 is rotated by driving the seat motor 215, the support body 212 of the seat main body 211 can descend in the vertically downward direction (-Z-axis direction) along the two shafts 213 in association with the rotation of the trapezoidal screw 214 as shown in Fig. 7, and can ascend in the vertical upward direction (+Z-axis direction) along the two shafts 213 in association with the rotation of the trapezoidal screw 214 as shown in Fig. 8.

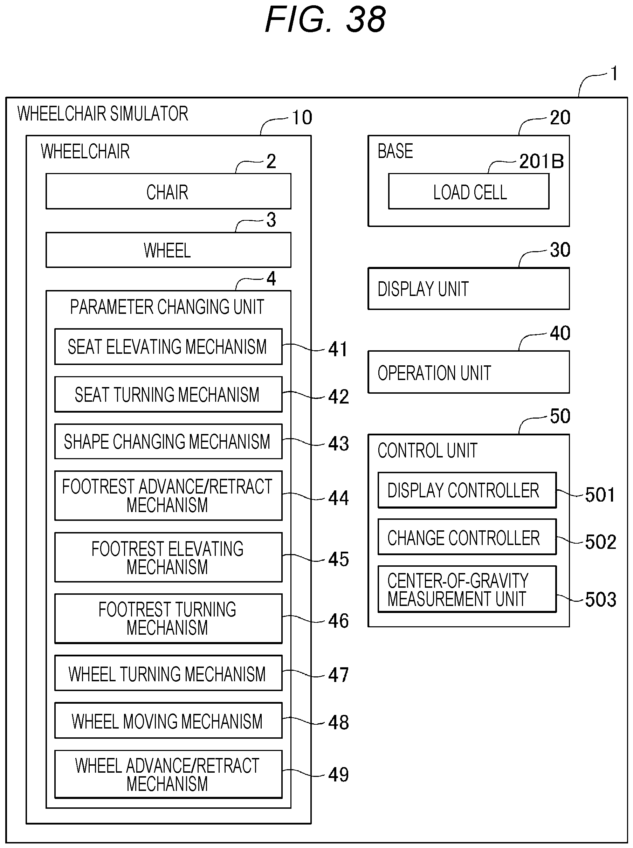

Therefore, in the present embodiment, the support body 212, the two shafts 213, the trapezoidal screw 214, and the seat motor 215 function as a seat elevating mechanism 41 (see Fig. 38) that raises and lowers the seat main body 211.

In addition, as shown in Fig. 5, the seat main body 211 has an end on the rear side (-X-axis direction side) fixed to the support body 212 turnably about a pivot shaft 211A (Y-axis). Furthermore, the end of the bottom surface of the seat main body 211 on the +X-axis direction side is connected to the support body 212 via a seat linear actuator 216.

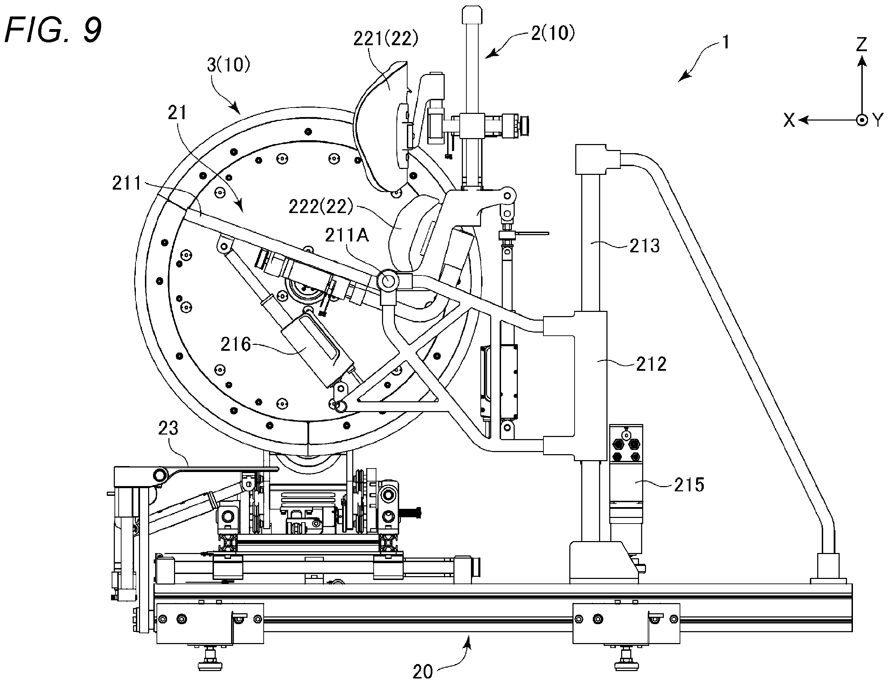

Fig. 9 is a view showing a state in which the seat of the chair is turned.

As shown in Fig. 9, the seat main body 211 turns about the Y axis (clockwise in the drawing) by driving the seat linear actuator 216 to extend the seat linear actuator 216.

Therefore, in the present embodiment, the pivot shaft 211A and the seat linear actuator 216 function as a seat turning mechanism 42 (see Fig. 38) that turns the seat main body 211.

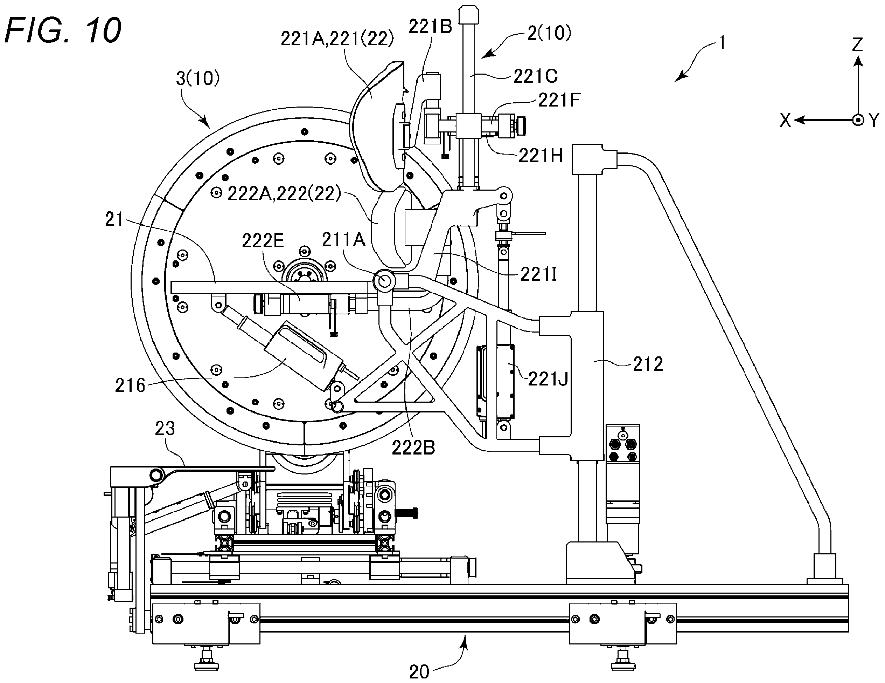

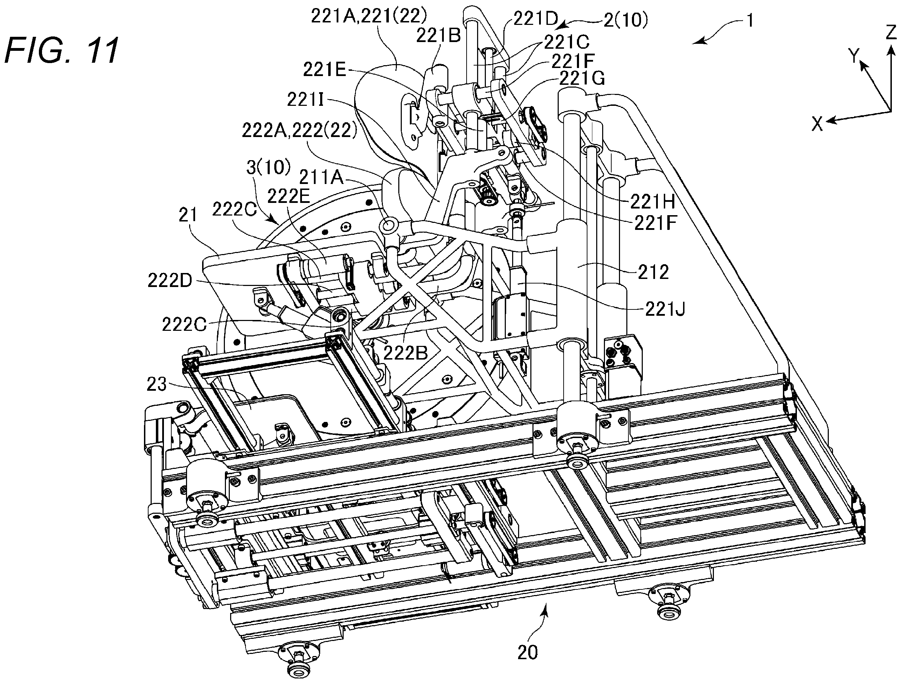

Fig. 10 is a left side view showing the backrest of the chair. Specifically, Fig. 10 is a view showing a state in which the left wheel 3 is removed in the left side view of the wheelchair 10 in Fig. 3. Fig. 11 is a perspective view showing the shape changing mechanism that changes the shape of the backrest of the chair.

As shown in Figs. 10 and 11, the backrest 22 includes a back support 221 as a back support member that supports the back of the user and a lumbar support 222 as a lower-back support member that supports the lower back of the user.

The back support 221 includes a back support main body 221A that is a part that supports the back of the user, a support body 221B that supports an end of the back support main body 221A on the rear side (-X axis direction side), two shafts 221C that support the support body 221B in a freely ascending and descending manner, a trapezoidal screw 221D (see Fig. 11) that is screwed with the support body 221B and attached between the two shafts 221C, and a back support elevating motor 221E that rotates the trapezoidal screw 221D.

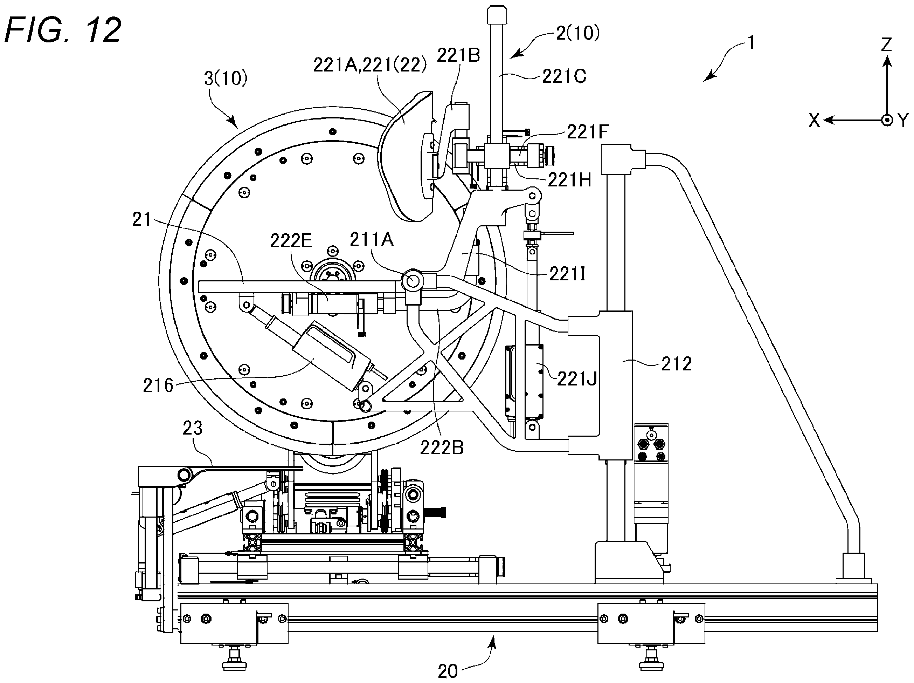

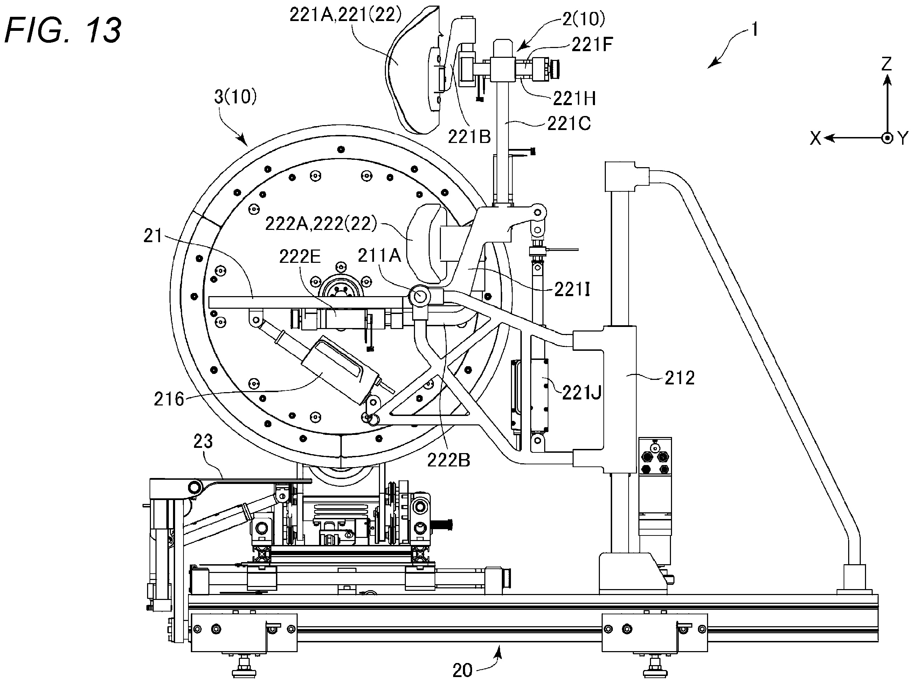

Fig. 12 is a view showing a state in which the back support of the chair is lowered. Fig. 13 is a view showing a state in which the back support of the chair is raised.

When the trapezoidal screw 221D is rotated by driving the back support elevating motor 221E, the support body 221B of the back support main body 221A can be lowered in the vertically downward direction (-Z-axis direction) along the two shafts 221C as shown in Fig. 12 in association with the rotation of the trapezoidal screw 221D, and can be raised in the vertical upward direction (+Z-axis direction) along the two shafts 221C as shown in Fig. 13 in association with the rotation of the trapezoidal screw 221D.

Therefore, in the present embodiment, the support body 221B, the two shafts 221C, the trapezoidal screw 221D, and the back support elevating motor 221E function as a shape changing mechanism 43 (see Fig. 38) that changes the shape of the backrest 22.

In addition, as shown in Figs. 10 and 11, the back support 221 includes two shafts 221F inserted into both sides of the support body 221B in the Y axis direction, a trapezoidal screw 221G (see Fig. 11) screwed into the support body 221B and inserted into the center of the support body 221B in the Y axis direction, and a back support advance/retract motor 221H that rotates the trapezoidal screw 221G.

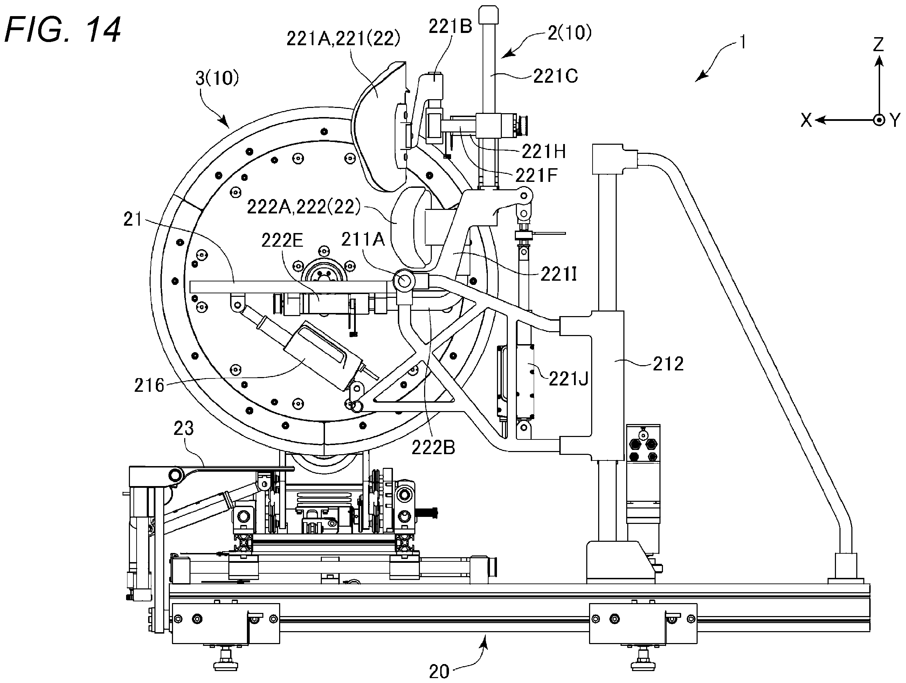

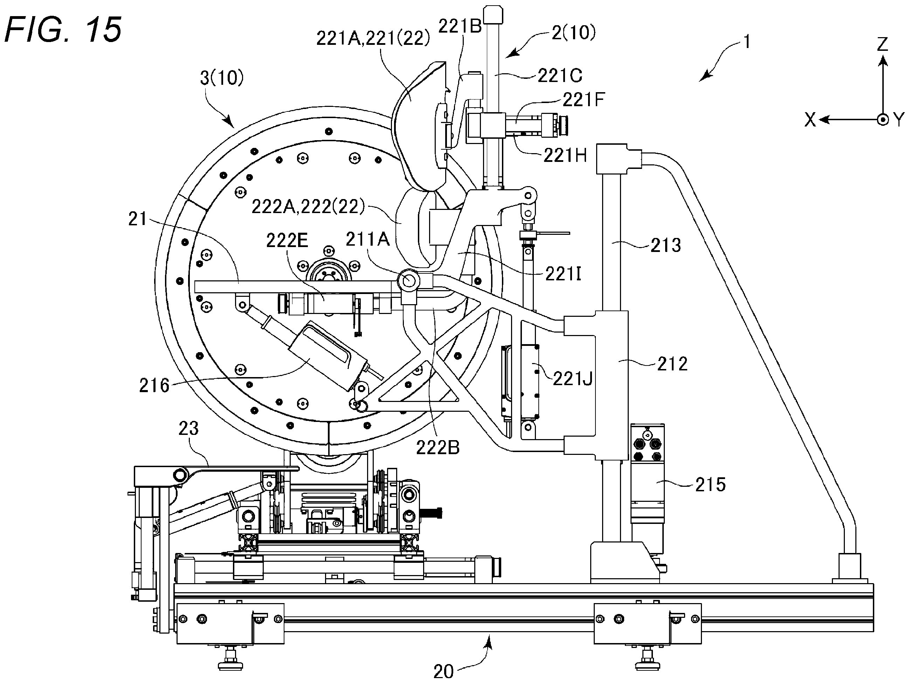

Fig. 14 is a view showing a state in which the back support of the chair is moved forward. Fig. 15 is a view showing a state in which the back support of the chair is retracted.

When the trapezoidal screw 221G is rotated by driving the back support advance/retract motor 221H, the support body 221B of the back support main body 221A can advance in the front direction (+X-axis direction) along the two shafts 221F with the rotation of the trapezoidal screw 221G as shown in Fig. 14, and can retract in the back direction (-X-axis direction) along the two shafts 221F with the rotation of the trapezoidal screw 221G as shown in Fig. 15.

Therefore, in the present embodiment, the support body 221B, the two shafts 221F, the trapezoidal screw 221G, and the back support advance/retract motor 221H function as the shape changing mechanism 43 (see Fig. 38) that changes the shape of the backrest 22.

In addition, as shown in Figs. 10 and 11, the back support 221 includes a base 221I that supports the two shafts 221C and the trapezoidal screw 221D. The end of the base 221I on a lower side (-Z axis direction side) is fixed to the support body 212 of the seat 21 turnably about the pivot shaft 211A (Y axis). Furthermore, the base 221I has an end on the ear side (-X-axis direction side) connected to the support body 212 via a back support linear actuator 221J.

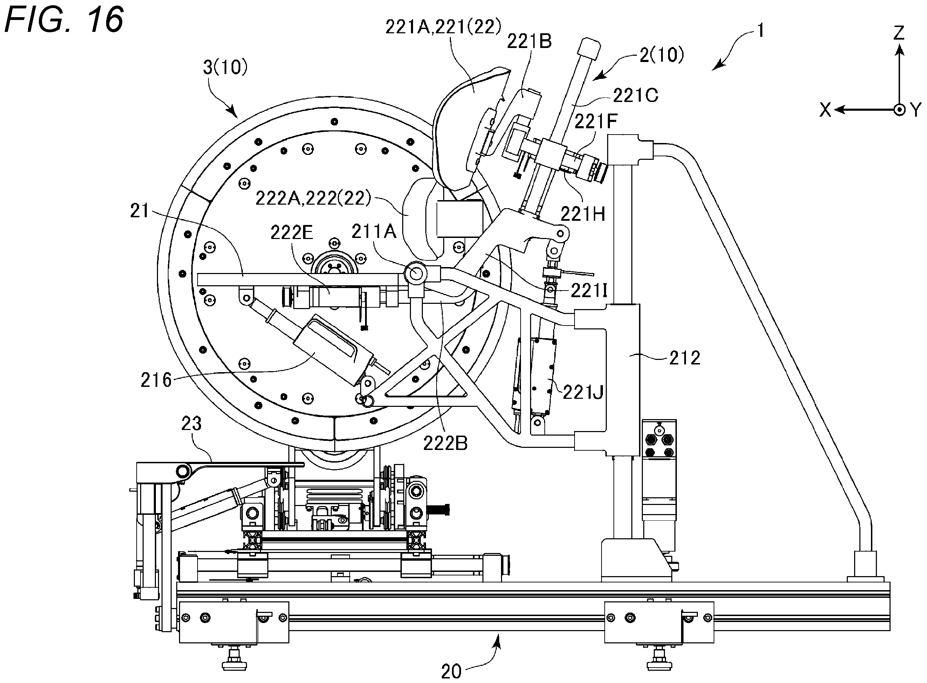

Fig. 16 is a view showing a state in which the back support of the chair is turned.

As shown in Fig. 16, the back support main body 221A turns about the Y axis (clockwise in the drawing) by driving the back support linear actuator 221J to contract the back support linear actuator 221J.

Therefore, in the present embodiment, the pivot shaft 211A and the back support linear actuator 221J function as the shape changing mechanism 43 (see Fig. 38) that changes the shape of the backrest 22.

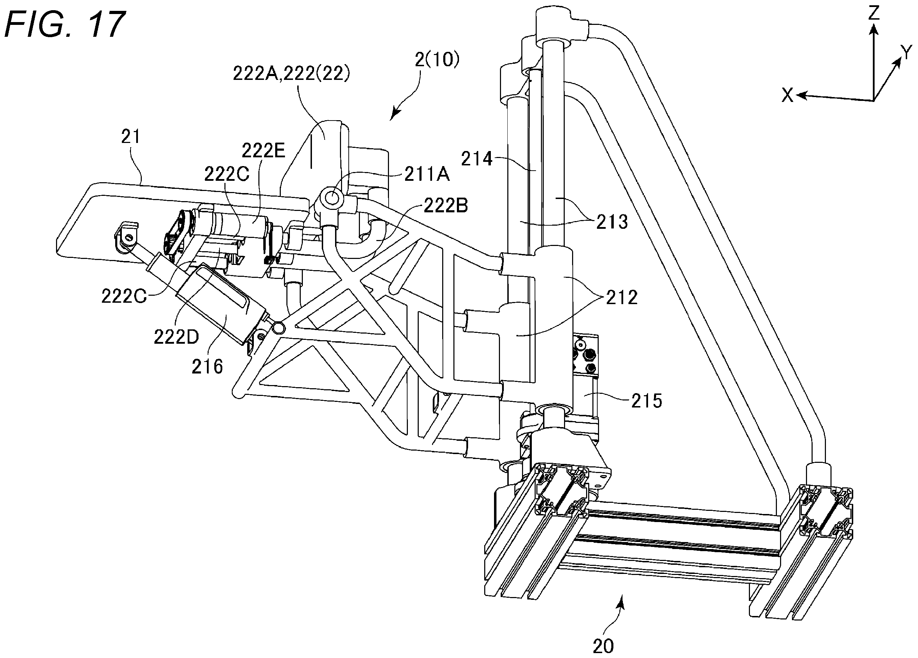

Fig. 17 is a perspective view showing the shape changing mechanism that changes the shape of the backrest of the chair. Specifically, Fig. 17 is a perspective view showing the shape changing mechanism 43 (see Fig. 38) that changes the shape of the lumbar support in the backrest of the chair.

As shown in Figs. 10, 11, and 17, the lumbar support 222 includes a lumbar support main body 222A which is a part that supports the lower back of the user, a support body 222B in a substantially L-shaped that supports the lumbar support main body 222A, two shafts 222C (see Figs. 11 and 17) that supports the support body 222B so as to freely advance and retract, a trapezoidal screw 222D (see Figs. 11 and 17) screwed with the support body 222B and attached between the two shafts 222C, and a lumbar support advance/retract motor 222E that rotates the trapezoidal screw 222D.

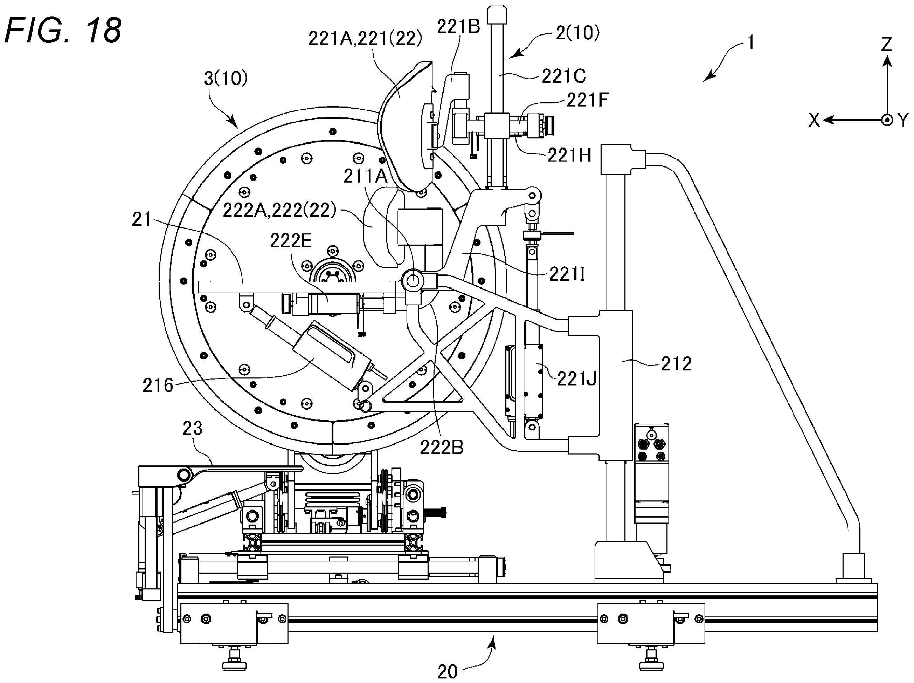

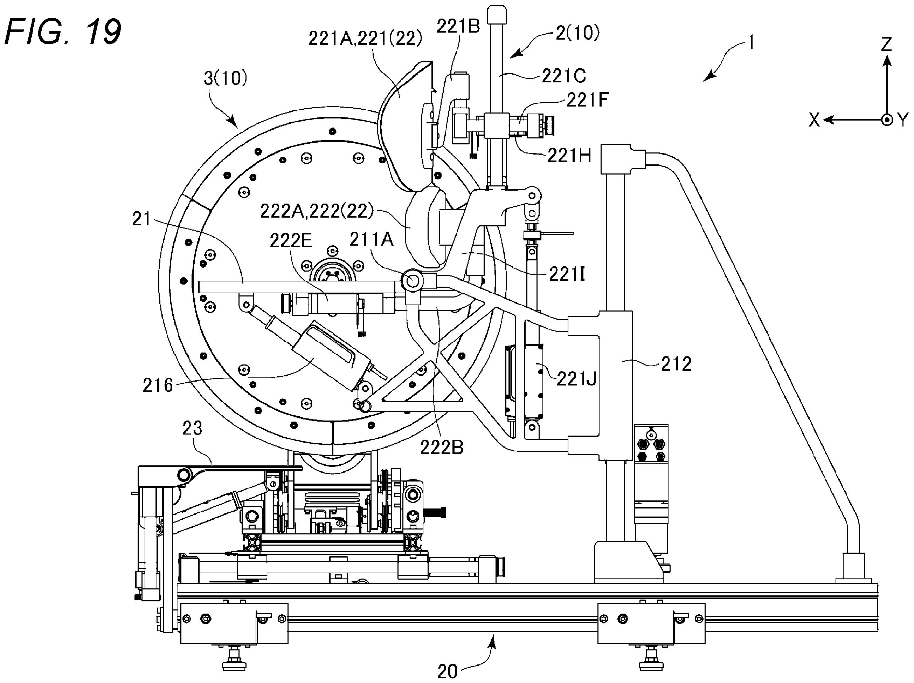

Fig. 18 is a view showing a state in which the lumbar support of the chair is moved forward. Fig. 19 is a view showing a state in which the lumbar support of the chair is retracted.

When the trapezoidal screw 222D is rotated by driving the lumbar support advance/retract motor 222E, the support body 222B of the lumbar support main body 222A can advance in the front direction (+X-axis direction) along the two shafts 222C as shown in Fig. 18 in association with the rotation of the trapezoidal screw 222D, and can retract in the back direction (-X-axis direction) along the two shafts 222C as shown in Fig. 19 in association with the rotation of the trapezoidal screw 222D.

Therefore, in the present embodiment, the support body 222B, the two shafts 222C, the trapezoidal screw 222D, and the lumbar support advance/retract motor 222E function as the shape changing mechanism 43 (see Fig. 38) that changes the shape of the backrest 22.

In addition, in the present embodiment, the shape changing mechanism 43 also functions as a support member advance/retract mechanism that advances and retracts the positions of the back support 221 and the lumbar support 222 forward and backward.

Note that in the present embodiment, the support member advance/retract mechanism advances and retracts both positions of the back support 221 and the lumbar support 222 forward and backward, but it is sufficient that the position of the at least one can be advanced and retracted forward and backward.

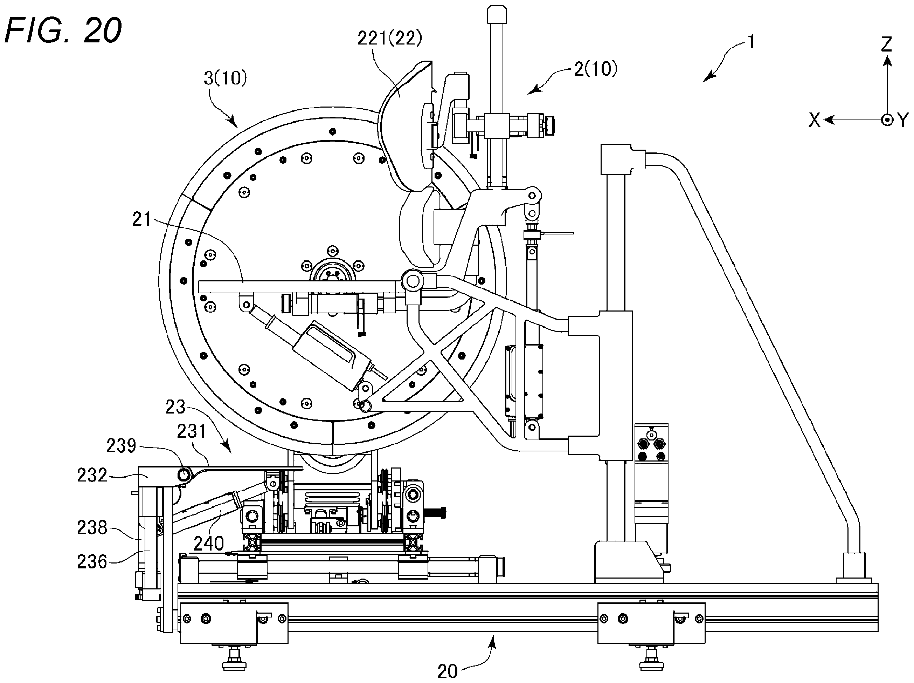

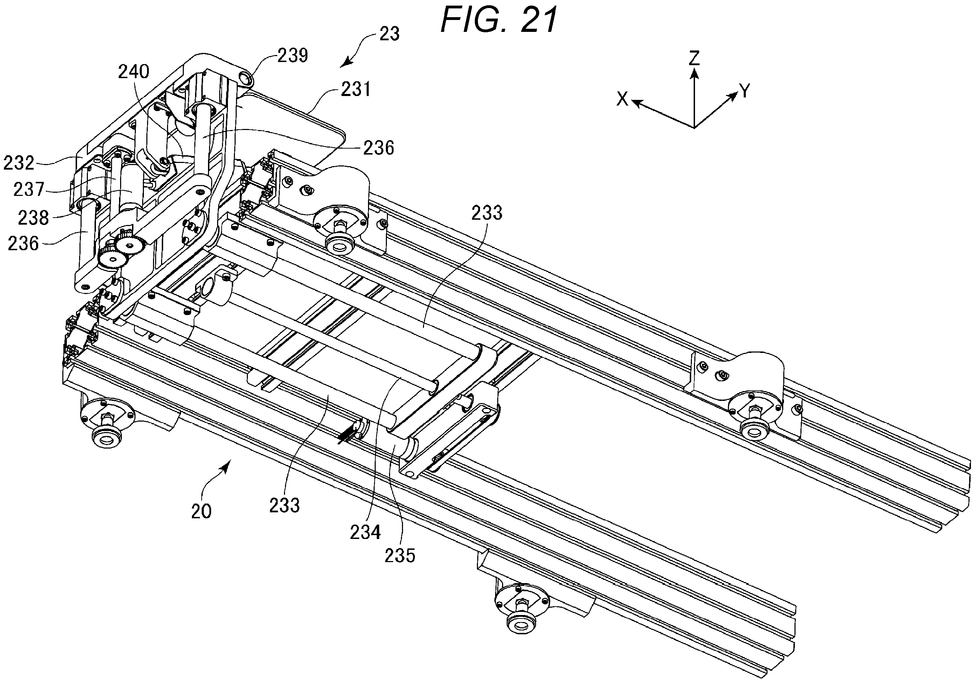

Fig. 20 is a left side view showing the footrest of the chair. Specifically, Fig. 20 is a view showing a state in which the left wheel 3 is removed in the left side view of the wheelchair 10 in Fig. 3. Fig. 21 is a perspective view showing a footrest advance/retract mechanism that advances and retracts the position of the footrest of the chair forward and backward.

As shown in Figs. 20 and 21, the footrest 23 includes a footrest main body 231 that is a part on which a user places a foot, a support body 232 that supports the footrest main body 231, two shafts 233 (see Fig. 21) that support the support body 232 so as to be movable forward and backward, a trapezoidal screw 234 (see Fig. 21) that is screwed into the support body 232 and is attached between the two shafts 233, and a footrest advance/retract motor 235 (see Fig. 21) that rotates the trapezoidal screw 234.

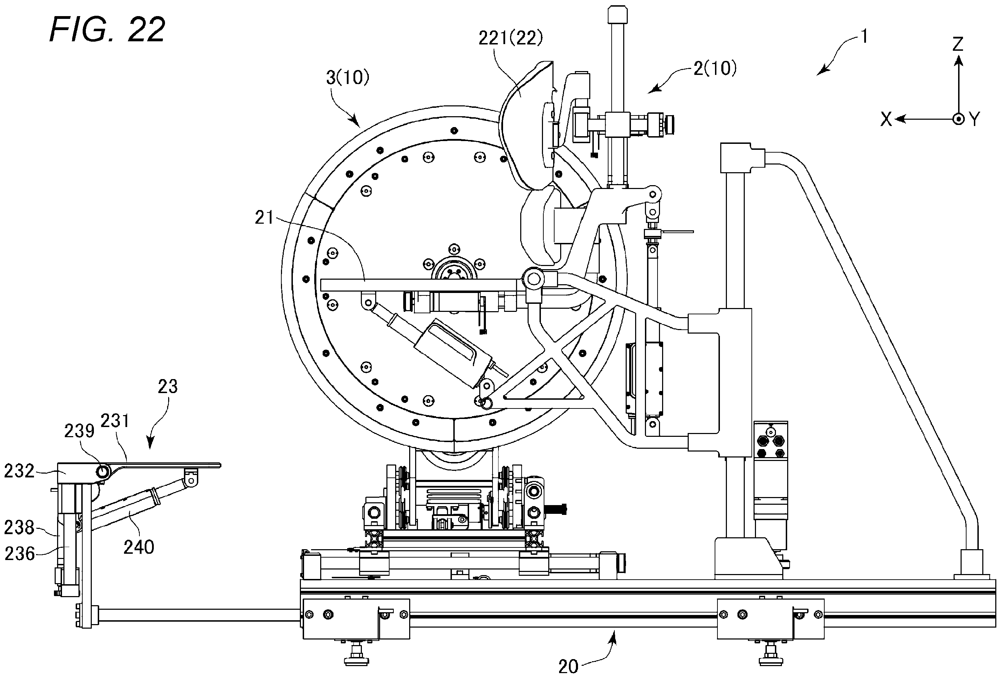

Fig. 22 is a view showing a state in which the footrest of the chair is moved forward.

When the trapezoidal screw 234 is rotated by driving the footrest advance/retract motor 235, the support body 232 of the footrest main body 231 can advance in the front direction (+X-axis direction) along the two shafts 233 as shown in Fig. 22 in association with the rotation of the trapezoidal screw 234, and can retract in the back direction (-X-axis direction) along the two shafts 222C as shown in Fig. 20 in association with the rotation of the trapezoidal screw 234.

Therefore, in the present embodiment, the support body 232, the two shafts 233, the trapezoidal screw 234, and the footrest advance/retract motor 235 function as a footrest advance/retract mechanism 44 (see Fig. 38) that advances and retracts the footrest main body 231.

**In** addition, as shown in Figs. 20 and 21, the footrest 23 includes two shafts 236 inserted into the support body 232 on both sides in the Y axis direction, a trapezoidal screw 237 (see Fig. 21) screwed into the support body 232 and inserted into a center of the support body 232 in the Y axis direction, and a footrest elevating motor 238 that rotates trapezoidal screw 237.

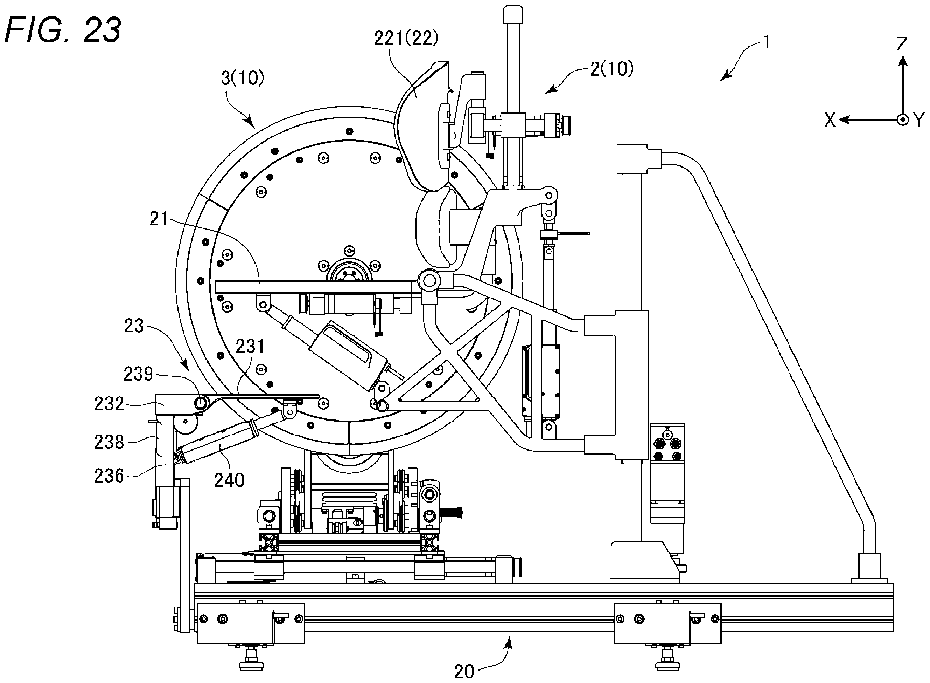

Fig. 23 is a view showing a state in which the footrest of the chair is raised.

When the trapezoidal screw 237 is rotated by driving the footrest elevating motor 238, the support body 232 of the footrest main body 231 can be lowered in the vertically downward direction (-Z-axis direction) along the two shafts 236 as shown in Fig. 20 in association with the rotation of the trapezoidal screw 237, and can be raised in the vertical upward direction (+Z-axis direction) along the two shafts 236 as shown in Fig. 23 in association with the rotation of the trapezoidal screw 237.

Therefore, in the present embodiment, the support body 221B, the two shafts 236, the trapezoidal screw 237, and the footrest elevating motor 238 function as a footrest elevating mechanism 45 (see Fig. 38) that raises and lowers the footrest main body 231.

Furthermore, as shown in Figs. 20 and 21, the footrest main body 231 has an end on the front side (+X-axis direction side) turnably fixed to the support body 232 about a pivot shaft 239 (Y-axis). Furthermore, the footrest main body 231 has an end on the -X-axis direction side of the bottom surface connected to the support body 232 via the footrest linear actuator 240.

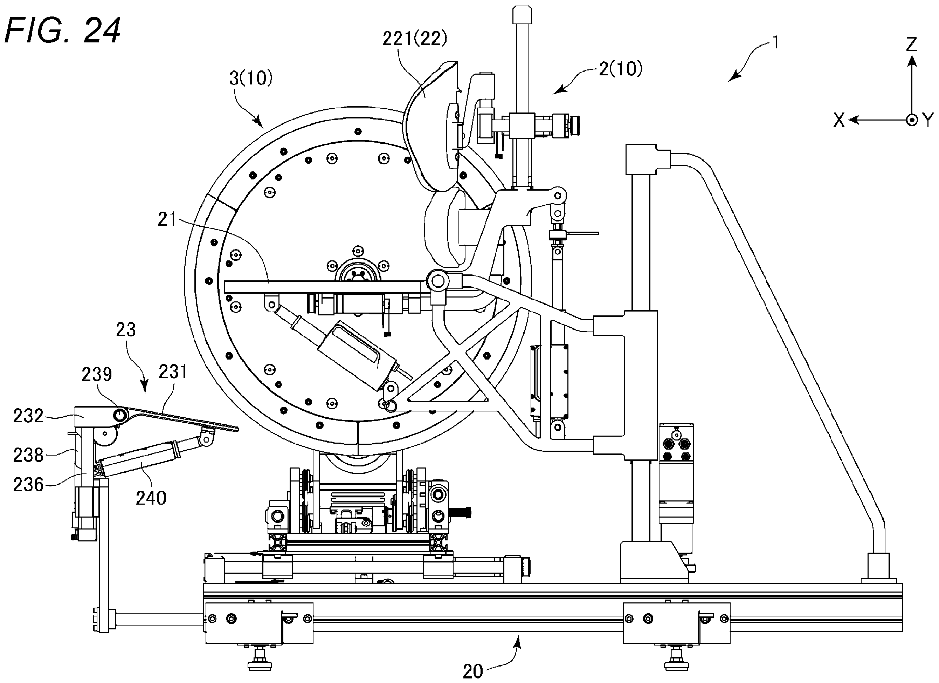

Fig. 24 is a view showing a state in which the footrest of the chair is turned.

As shown in Fig. 24, the footrest main body 231 turns about the Y axis (clockwise in the drawing) by driving the footrest linear actuator 240 to contract the footrest linear actuator 240.

Therefore, in the present embodiment, the pivot shaft 239 and the footrest linear actuator 240 function as a footrest turning mechanism 46 (see Fig. 38) that turns the footrest main body 231.

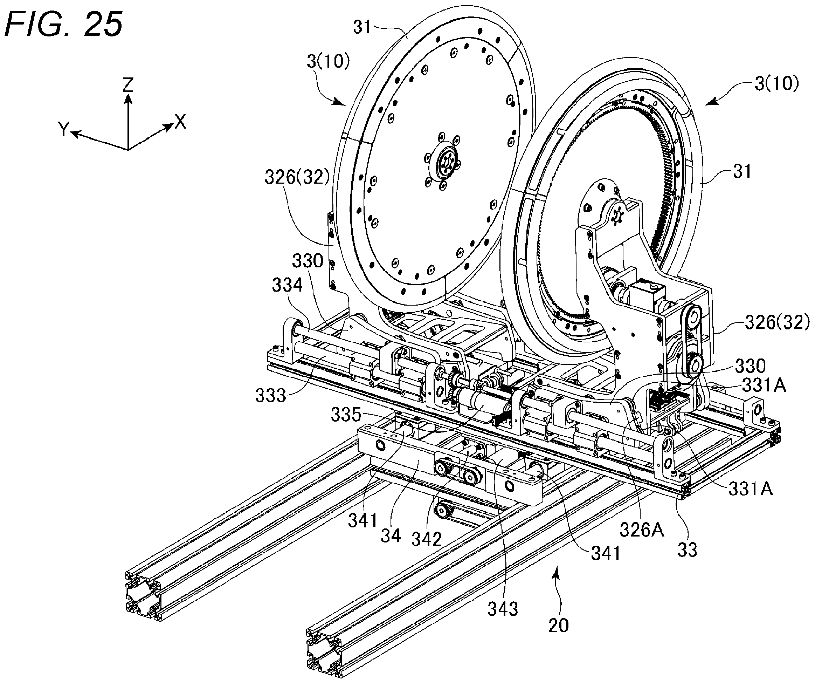

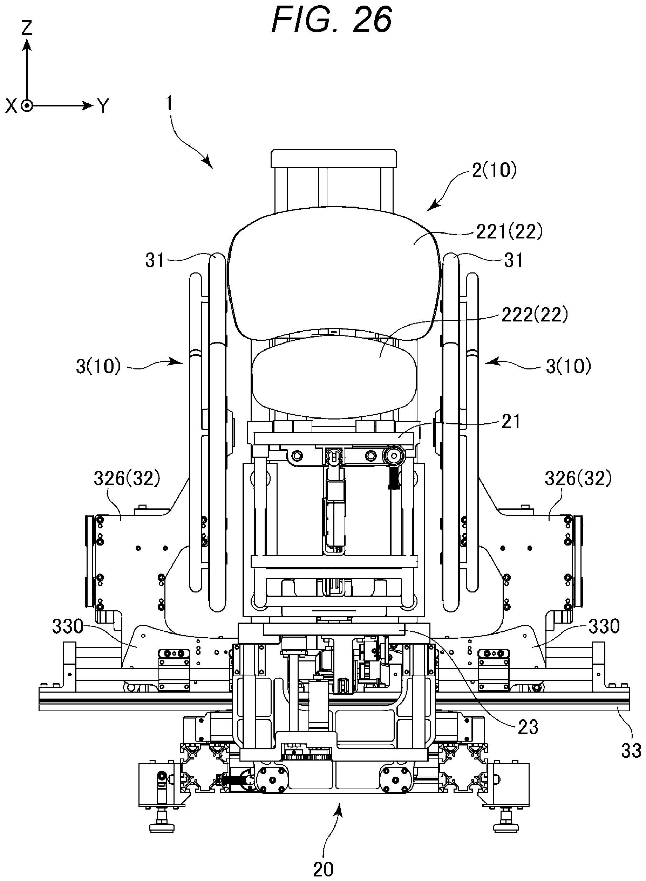

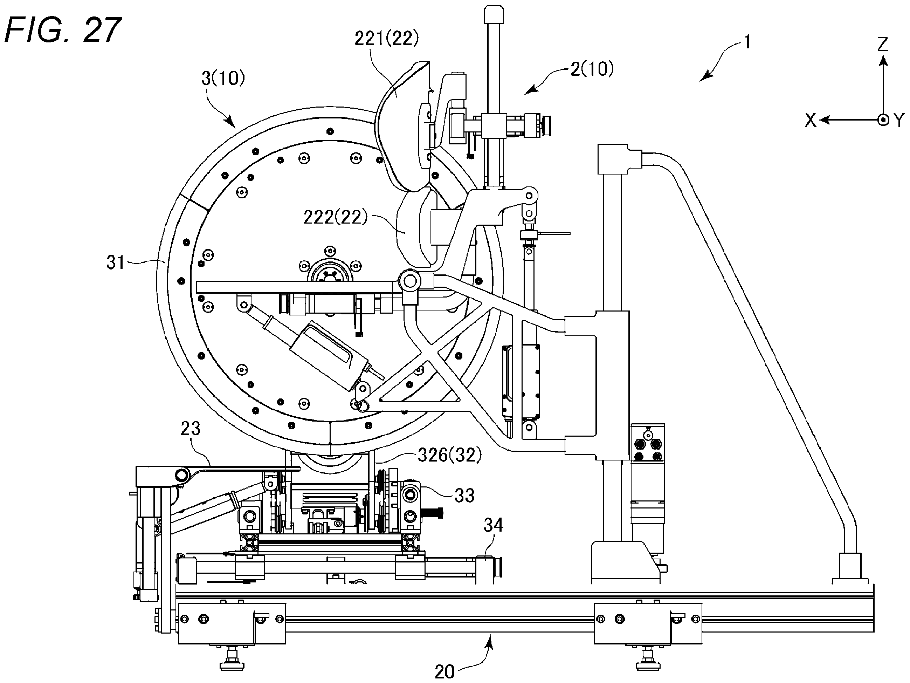

Fig. 25 is a perspective view showing wheels of a wheelchair. Fig. 26 is a front view showing a normal position of the wheel of the wheelchair. Fig. 27 is a left side view showing a normal position of the wheel of the wheelchair. Fig. 25 is a view showing a state in which the chair 2 of the wheelchair 10 is removed. In addition, Fig. 27 is a left side view of the wheelchair 10 showing a state in which the left wheel 3 is removed.

As shown in Figs. 25 to 27, the wheel 3 includes a pair of wheel main bodies 31 arranged side by side on the chair 2, a pair of wheel support bodies 32 rotatably supporting each wheel main body 31, a wheel moving base 33 on which each wheel support body 32 is placed and which moves each wheel support body 32 along the Y-axis direction, and a wheel advance/retract base 34 which advances and retracts the wheel moving base 33 along the X-axis direction. Here, the wheel advance/retract base 34 is placed on the base 20.

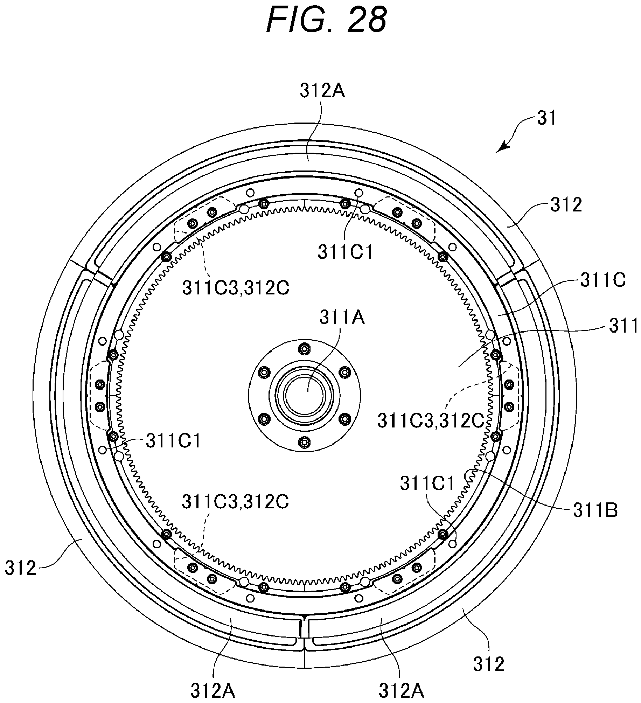

Fig. 28 is a view showing the wheel main body.

As shown in Fig. 28, the wheel main body 31 includes a wheel plate 311 in a disk shape and three attachments 312 detachably attached to the wheel plate 311 along a peripheral edge of the wheel plate 311.

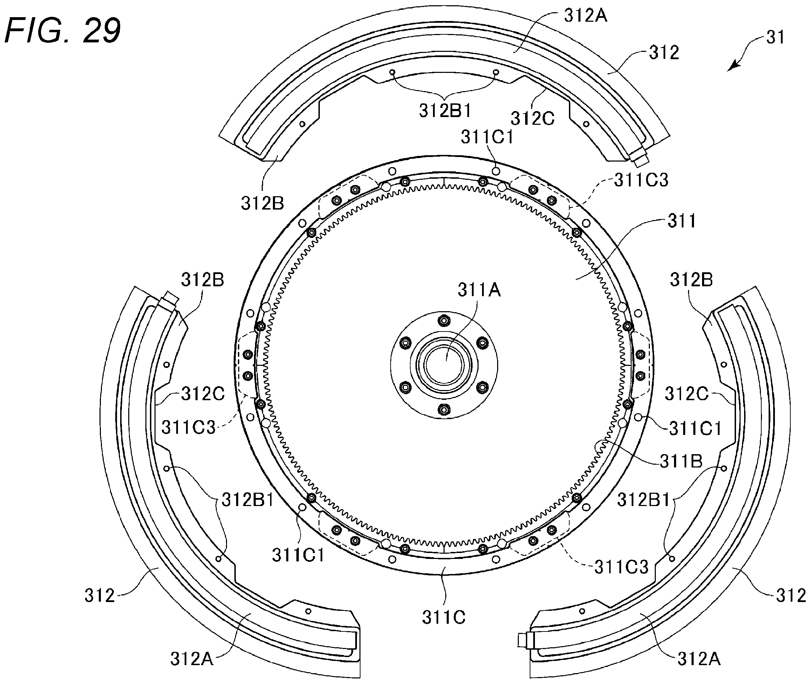

Fig. 29 is a view showing a state in which the attachments are removed from the wheel plate.

As shown in Fig. 29, the wheel plate 311 includes a shaft hole 311A formed at the center position, an internal gear 311B formed along the peripheral edge, and a flange 311C formed outside the internal gear 311B.

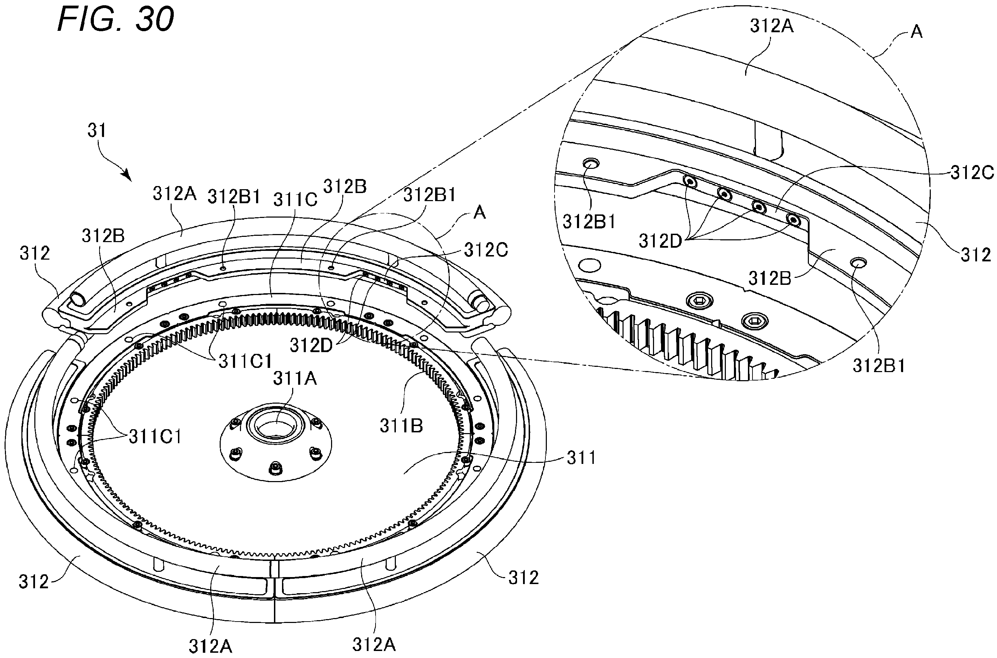

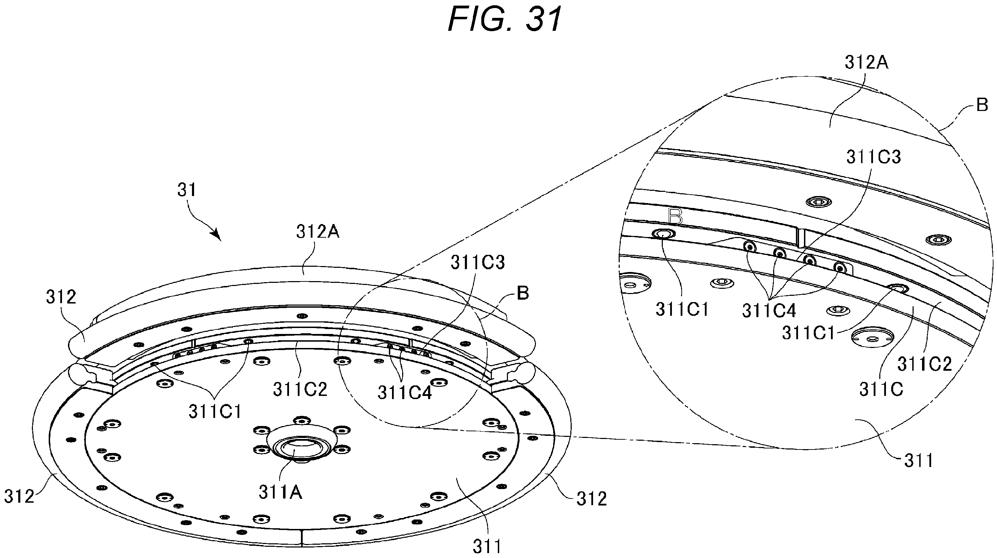

Fig. 30 is an enlarged view showing a connecting part between the flange of the wheel plate and the attachment as viewed from the wheel support body side. Fig. 31 is an enlarged view showing the connecting part between the flange of the wheel plate and the attachment as viewed from the chair side.

As shown in Figs. 30 and 31, the flange 311C includes a plurality of sets of plungers 311C1 arranged at regular intervals along the outer peripheral edge of the wheel plate 311, each set including two plungers arranged with a predetermined distance therebetween.

In addition, as shown in Fig. 31, the flange 311C includes a slit 311C2 formed in a groove shape toward the center of the wheel plate 311 along the outer peripheral edge of the wheel plate 311. The slit 311C2 includes a protrusion 311C3 formed between the pair of plungers 311C1 and a magnet 311 C4 attached to the protrusion 311C3.

As shown in Fig. 30, the attachment 312 includes a hand rim 312A that is a part on which a user places a hand, ribs 312B formed along an inner peripheral edge of the attachment 312 with a predetermined distance therebetween, a recess 312C formed between the ribs 312B, and a magnet 312D attached to the recess 312C. The rib 312B includes a plunger fitting hole 312B 1 formed at a position corresponding to the plunger 311C1 of the flange 311C.

The attachment 312 is connected to the wheel plate 311 by inserting the rib 312B into the slit 311C2 of the flange 311C. Here, since the protrusion 311C3 of the flange 311C and the recess 312C of the attachment 312 are fitted, the attachment 312 is positioned with respect to the wheel plate 311. In addition, since the plunger 311C1 of the flange 311C is fitted in the plunger fitting hole 312B1 of the attachment 312, the attachment 312 is fixed to the wheel plate 311. Furthermore, since the magnet 311C4 of the flange 311C and the magnet 312D of the attachment 312 attract each other, the attachment 312 is fixed to the wheel plate 311.

Therefore, in the present embodiment, the wheel 3 is configured to be separable into a plurality of parts (attachments 312) and is configured to be detachable from the chair 2.

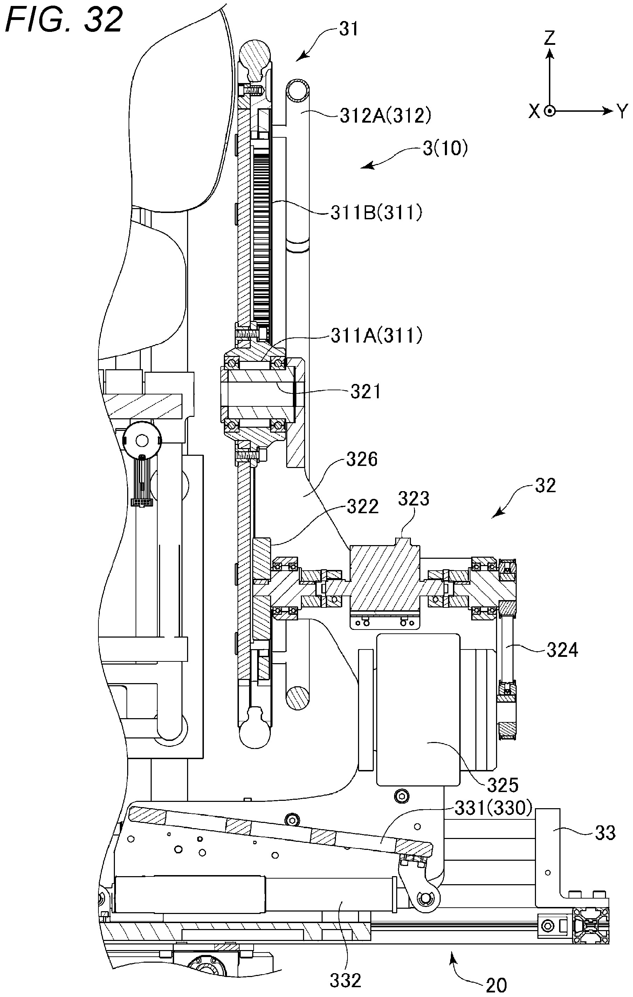

Fig. 32 is a view showing a cross section of the wheel main body and the wheel support body.

As shown in Fig. 32, the wheel support body 32 includes a rotating shaft body 321 that is inserted into a shaft hole 311A of the wheel plate 311 to rotatably support the wheel plate 311, an external gear 322 that is fitted to an internal gear 311B of the wheel plate 311, a torque meter 323 having one end connected to the external gear 322 and that detects torque of the external gear 322, a timing belt 324 attached to the other end of the torque meter 323, and a rotational load motor 325 that applies a load to rotation of the wheel plate 311 by transmitting a rotational load to the timing belt 324. The rotating shaft body 321, the external gear 322, the torque meter 323, the timing belt 324, and the rotational load motor 325 are fixed to the frame 326.

Here, as shown in Figs. 25 and 26, the frame 326 of the wheel support body 32 is attached to the fan-shaped member 330 placed on the wheel moving base 33 so as to be movable forward and backward along the Y-axis direction.

As shown in Fig. 25, the fan-shaped member 330 is formed in a shape that curves upward (+Z-axis direction) as being separated from the wheel main body 31. **In** addition, the fan-shaped member 330 includes a plurality of sets of rollers 331A arranged at regular intervals along the curved shape of the fan-shaped member 330, each set including two rollers arranged with a predetermined distance therebetween in the vertical direction.

The frame 326 includes a rail member 326A formed in a shape curved upward (+Z-axis direction) as being separated from the wheel main body 31 so as to correspond to the fan-shaped member 330. The rail member 326A is slidably sandwiched by each pair of rollers 331A.

As shown in Fig. 32, the fan-shaped member 330 includes a link 331 attached to the frame 326 and a wheel linear actuator 332 having one end connected to the link 331 and the other end fixed to the fan-shaped member 330.

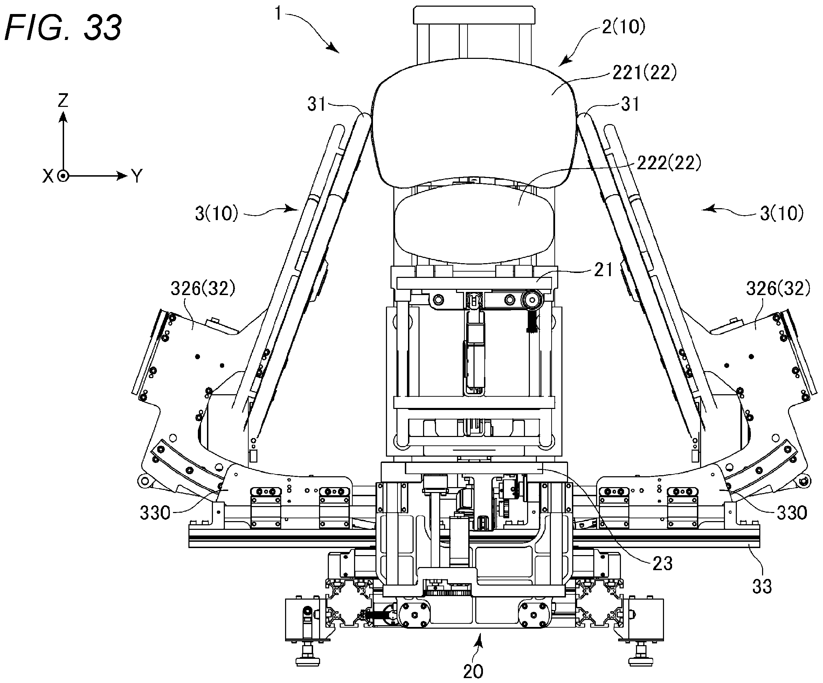

Fig. 33 is a view showing a state in which the wheel support body is turned.

As shown in Fig. 33, the fan-shaped member 330 turns about the X axis by driving the wheel linear actuator 332 to extend the wheel linear actuator 332.

Therefore, in the present embodiment, the rail member 326A, the link 331, the roller 331A, and the wheel linear actuator 332 function as a wheel turning mechanism 47 (see Fig. 38) that rotates the wheel main body 31.

**In** addition, as shown in Fig. 25, the wheel moving base 33 includes a shaft 333 that extends along the Y-axis direction and movably supports the fan-shaped member 330 along the Y-axis direction, a trapezoidal screw 334 that extends along the Y-axis direction and is screwed with the fan-shaped member 330, and a wheel moving motor 335 that rotates the trapezoidal screw 334.

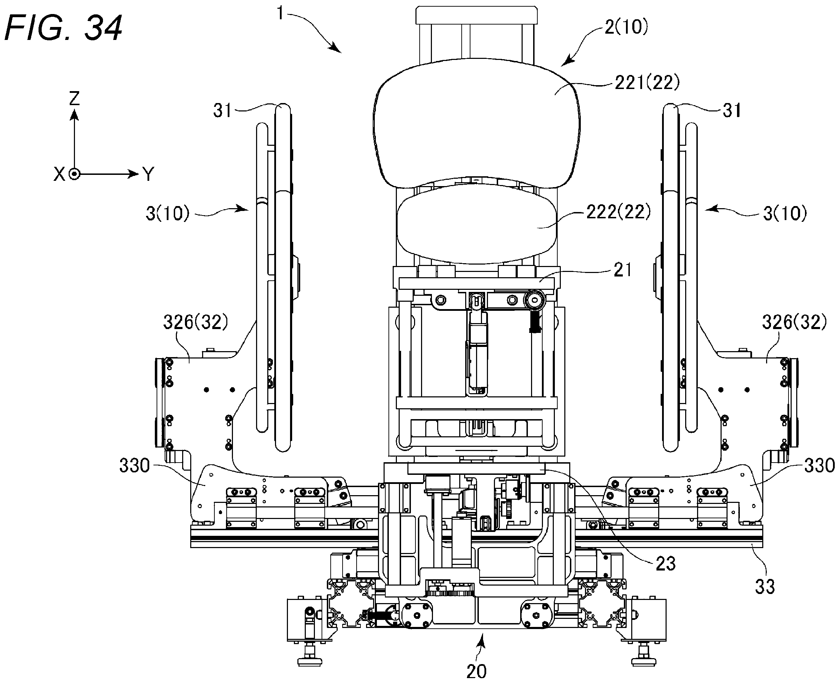

Fig. 34 is a view showing a state in which the wheel support body is moved.

When the trapezoidal screw 334 is rotated by driving the wheel moving motor 335, the fan-shaped member 330 of the wheel moving base 33 can move along the shaft 333 in association with the rotation of the trapezoidal screw 334 as shown in Fig. 34.

Therefore, in the present embodiment, the fan-shaped member 330, the shaft 333, the trapezoidal screw 334, and the wheel moving motor 335 function as a wheel moving mechanism 48 (see Fig. 38) that moves the wheel main body 31.

As shown in Fig. 25, the wheel advance/retract base 34 includes two shafts 341 that extend along the X-axis direction and movably support the wheel moving base 33 along the X-axis direction, a trapezoidal screw 342 that extends along the X-axis direction and is screwed with the wheel moving base 33, and a wheel advance/retract motor 343 that rotates the trapezoidal screw 342.

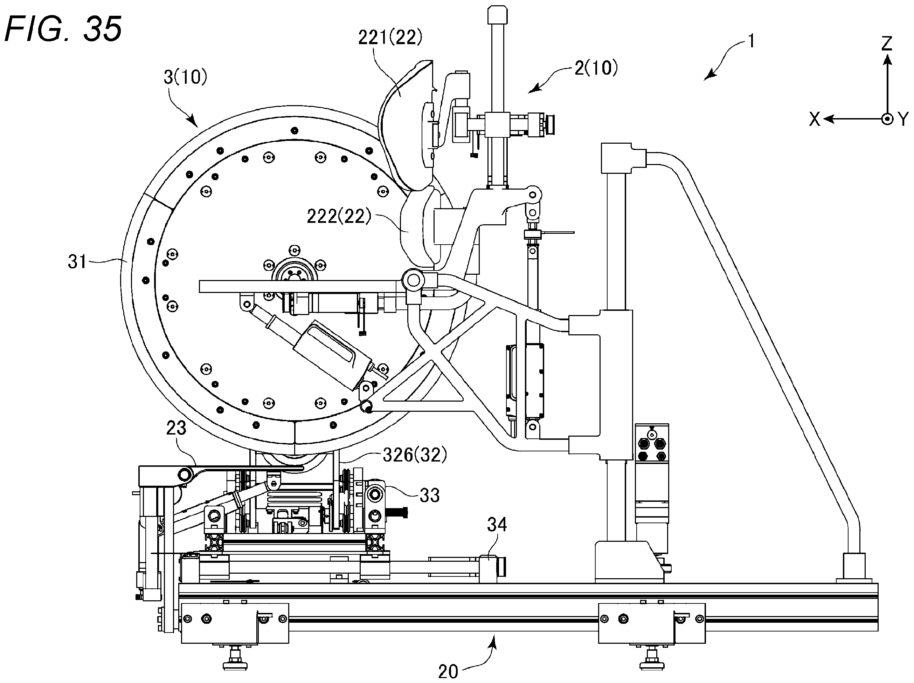

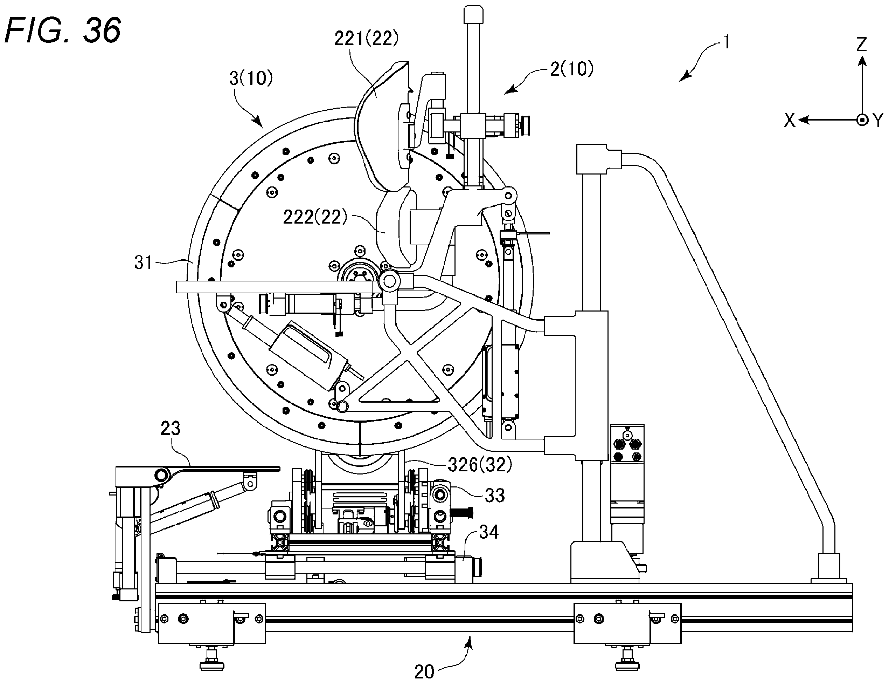

Fig. 35 is a view showing a state in which the wheel moving base is moved forward. Fig. 36 is a view showing a state in which the wheel moving base is retracted.

When the trapezoidal screw 342 is rotated by driving the wheel advance/retract motor 343, the wheel moving base 33 can advance along the shaft 341 in association with the rotation of the trapezoidal screw 342 as shown in Fig. 35, and can retract along the shaft 341 in association with the rotation of the trapezoidal screw 342 as shown in Fig. 36.

Therefore, in the present embodiment, the wheel moving base 33, the two shafts 341, the trapezoidal screw 342, and the wheel advance/retract motor 343 function as a wheel advance/retract mechanism 49 (see Fig. 38) that advances and retracts the wheel main body 31.

As shown in Fig. 1, the base 20 is formed in a rectangular frame shape, and includes four leg members 201 attached at positions equidistant from the centers of the chair 2 and the wheels 3.

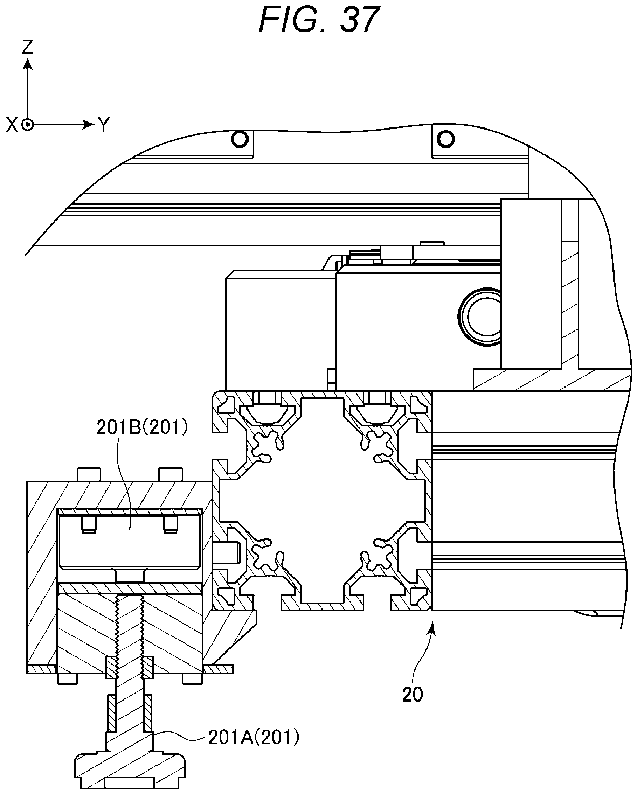

Fig. 37 is a view showing a cross section of the leg member of the base.

As shown in Fig. 37, each leg member 201 includes an adjuster 201A that adjusts the height of each leg member 201, and a load cell 201B as a load sensor that detects a load applied to the adjuster 201A.

Fig. 38 is a schematic configuration diagram showing an overall configuration of the wheelchair simulator.

As described above, the wheelchair simulator 1 includes the wheelchair 10 including the chair 2 on which the user sits and the pair of wheels 3 arranged side by side on the chair 2, and the base 20 that supports the entire wheelchair 10. In addition, as shown in Fig. 38, the wheelchair simulator 1 includes a display unit 30 that displays information, an operation unit 40 that receives an operation input of the user, and a control unit 50 that controls the entire wheelchair simulator 1.
in addition, the wheelchair 10 includes a parameter changing unit 4 that changes a parameter related to the structure of the wheelchair 10.

The parameter changing unit 4 includes the above-described various mechanisms of the seat elevating mechanism 41, the seat turning mechanism 42, the shape changing mechanism 43, the footrest advance/retract mechanism 44, the footrest elevating mechanism 45, the footrest turning mechanism 46, the wheel turning mechanism 47, the wheel moving mechanism 48, and the wheel advance/retract mechanism 49.

The control unit 50 includes a central processing unit (CPU), a memory, and the like, and executes information processing according to a predetermined program stored in the memory. The control unit 50 includes a display controller 501, a change controller 502, and a center-of-gravity measurement unit 503.

The display controller 501 causes the display unit 30 to display the parameter changed via the parameter changing unit 4.

The change controller 502 causes the parameter changing unit 4 to change the parameter based on the operation input received via the operation unit 40. Therefore, the display controller 501 causes the display unit 30 to display the parameter changed by the change controller 502.

Here, the change controller 502 can cause the seat elevating mechanism 41 and the seat turning mechanism 42 to raise, lower, and turn the seat main body 211. The change controller 502 can cause the shape changing mechanism 43 to change the shape of the backrest 22. The change controller 502 can cause the footrest advance/retract mechanism 44, the footrest elevating mechanism 45, and the footrest turning mechanism 46 to advance, retract, raise, lower, and turn the footrest main body 231. The change controller 502 can cause the wheel turning mechanism 47, the wheel moving mechanism 48, and the wheel advance/retract mechanism 49 to turn, move, and advance and retract the wheel main body 31.

The change controller 502 can apply a load to the rotation of the wheel plate 311 by causing the parameter changing unit 4 to drive the rotational load motor 325.

The center-of-gravity measurement unit 503 measures the center of gravity on the seat 21 based on the load applied to the base 20 detected by the load cell 201B. **In** addition, the display controller 501 causes the display unit 30 to display the center of gravity on the seat 21 measured by the center-of-gravity measurement unit 503.

According to the present embodiment as described above, it is possible to achieve the following operations and effects.
(1) Since the control unit 50 includes the display controller 501 that causes the display unit 30 to display the parameter changed via the parameter changing unit 4, the user can change the parameter (height and angle of seat 21, width, angle, and load of wheel 3, and the like) related to the structure of the wheelchair 10 according to preference, and the user can confirm the parameter by the display unit 30. Therefore, the wheelchair simulator 1 makes it possible to perform a simulation for manufacturing the wheelchair according to the preference of the user, and the wheelchair manufacturer can manufacture the wheelchair according to the preference of the user without complicating the structure of the wheelchair based on the result of the simulation.
(2) Since the parameter changing unit 4 includes the shape changing mechanism 43 that changes the shape of the backrest 22, the user can change the shape of the backrest 22 according to the user's preference.
(3) Since the shape changing mechanism 43 includes the shape changing mechanism 43 that moves the position of at least one of the back support 221 and the lumbar support 222 forward and backward, it is possible to change the position of at least one of the back support 221 and the lumbar support 222 . Therefore, the shape changing mechanism 43 makes it possible to change the shape of the backrest 22, and it is possible to test the shape that effectively supports the back and the lower back.
(4) Since the parameter changing unit 4 includes the seat elevating mechanism 41 that raises and lowers the seat 21, it is possible to change the height of the seat 21 with respect to the wheel 3 by raising and lowering the seat 21, and it is possible to appropriately perform the simulation. In addition, since the parameter changing unit 4 makes it possible to lower the seat 21, the user can easily transfer from the wheelchair on which the user is riding to the seat 21 of the wheelchair 10 in the wheelchair simulator 1 as compared with the case in which the parameter changing unit 4 is configured to change the height of the wheel 3 with respect to the seat 21.
(5) Since the seat elevating mechanism 41 supports the rear end of the seat 21, it is unnecessary to dispose a member that supports the seat 21 on the front side of the seat 21, and it is possible to simplify the structure of the wheelchair 10. In addition, since it is unnecessary to arrange the member that supports the seat 21 on the front side of the seat 21, the user can easily transfer from the wheelchair on which the user is riding to the seat 21 of the wheelchair 10 in the wheelchair simulator 1.
(6) Since the parameter changing unit 4 includes the footrest advance/retract mechanism 44 that advances and retracts the position of the footrest 23 forward and backward, it is possible to change the position of the footrest 23, and it is possible to appropriately perform simulation. In addition, in a case in which it is unnecessary to dispose the member that supports the seat 21 on the front side of the seat 21, it is possible to retract the position of the footrest 23 to immediately below the seat 21, and it is possible to perform a simulation of the posture of sitting with the knee bent and the lower leg placed under the seat 21.
(7) The control unit 50 includes the change controller 502 that causes the parameter changing unit 4 to change the parameter based on the operation input received via the operation unit 40, and the display controller 501 causes the display unit 30 to display the parameter changed by the change controller 502. Therefore, the user can cause the control unit 50 to change the parameter related to the structure of the wheelchair 10 according to preference via the operation unit 40, and the user can confirm the parameter on the display unit 30. Therefore, the wheelchair simulator 1 makes it possible to improve the convenience of the user.
(8) Since the wheel 3 is configured to be separable into a plurality of parts and is configured to be detachable from the chair 2, it is possible to easily attach the wheel 3 having different diameters to the chair to change the diameter of the wheel 3.
(9) Since the display controller 501 causes the display unit 30 to display the center of gravity on the seat 21 measured by the center-of-gravity measurement unit 503, the user can confirm the center of gravity on the seat 21 by the display unit 30. Therefore, the wheelchair simulator 1 makes it possible to suitably perform the simulation for manufacturing the wheelchair according to the preference of the user.
(10) Since the center-of-gravity measurement unit 503 measures the center of gravity on the seat 21 based on the load applied to the base 20 detected by the load cell 201B, it is possible to accurately measure the center of gravity.

### [Modifications of Embodiment]

Note that the present invention is not limited to the foregoing embodiment, and modifications, improvements, and the like within a scope in which the object of the present invention can be achieved are included in the present invention.

For example, in the foregoing embodiment, the parameter changing unit 4 includes various mechanisms such as the seat elevating mechanism 41 that raises and lowers the seat 21 and the footrest advance/retract mechanism 44, but may be configured to change any parameter as long as the parameter is related to the structure of the wheelchair.

In the foregoing embodiment, the seat elevating mechanism 41 supports the rear end of the seat 21, but may support the front end or may support the bottom surface of the seat 21. In short, the seat elevating mechanism may support any part of the seat as long as the seat can be raised and lowered.

In the foregoing embodiment, the control unit 50 includes the change controller 502 that causes the parameter changing unit 4 to change the parameter based on the operation input received via the operation unit 40. On the other hand, the wheelchair simulator may be configured to cause the parameter changing unit to change the parameter manually by the user. In short, the wheelchair simulator does not necessarily have to include the change controller as long as the parameter changing unit can change the parameter, and the control unit may include a display controller that causes the display unit to display the parameter changed via the parameter changing unit.

In the foregoing embodiment, the wheel 3 is configured to be separable into a plurality of parts and configured to be detachable from the chair 2, but does not necessarily have to be configured to be separable into a plurality of parts and does not necessarily have to be configured to be detachable from the chair.

In the foregoing embodiment, the display controller 501 causes the display unit 30 to display the center of gravity on the seat 21 measured by the center-of-gravity measurement unit 503. However, the center of gravity on the seat 21 does not necessarily have to be displayed on the display unit 30.

In the foregoing embodiment, the center-of-gravity measurement unit 503 measures the center of gravity on the seat based on the load applied to the base 20 detected by the load cell 201B. However, a method different from this may be adopted as a method of measuring the center of gravity on the seat 21.

### INDUSTRIAL APPLICABILITY

As described above, the present invention is suitably usable for a wheelchair simulator.

### LIST OF REFERENCE SIGNS

- 1: Wheelchair simulator
- 2: Chair
- 3: Wheel
- 4: Parameter changing unit
- 10: Wheelchair
- 20: Base
- 21: Seat
- 22: Backrest
- 23: Footrest
- 30: Display unit
- 40: Operation unit
- 41: Seat elevating mechanism
- 42: Seat turning mechanism
- 43: Shape changing mechanism (support member advance/retract mechanism)
- 44: Footrest advance/retract mechanism
- 45: Footrest elevating mechanism
- 46: Footrest turning mechanism
- 47: Wheel turning mechanism
- 48: Wheel moving mechanism
- 49: Wheel advance/retract mechanism
- 50: Control unit
- 201B: Load cell (load sensor)
- 221: Back support (back support member)
- 222: Lumbar support (lower-back support member)
- 501: Display controller
- 502: Change controller
- 503: Center-of-gravity measurement unit

## Claims

1. A wheelchair simulator comprising:
a wheelchair including a chair having a seat and wheels attached to the chair;
a display unit configured to display information; and
a control unit configured to control the display unit, wherein
the wheelchair includes
a parameter changing unit configured to change a parameter related to a structure of the wheelchair, and
the control unit includes
a display controller that causes the display unit to display a parameter changed via the parameter changing unit.

2. The wheelchair simulator according to claim 1, wherein
the parameter changing unit includes a seat elevating mechanism that raises and lowers the seat.

3. The wheelchair simulator according to claim 2, wherein
the seat elevating mechanism supports a rear end of the seat.

4. The wheelchair simulator according to any one of claims 1 to 3, wherein
the wheelchair includes
a footrest, and
the parameter changing unit includes
a footrest advance/retract mechanism that advances and retracts a position of the footrest forward and backward.

5. The wheelchair simulator according to any one of claims 1 to 3, comprising
an operation unit configured to receive an operation input of a user, wherein
the control unit includes
a change controller that causes the parameter changing unit to change a parameter based on an operation input received via the operation unit, and
the display controller causes a display unit to display the parameter changed by the change controller.

6. The wheelchair simulator according to any one of claims 1 to 3, wherein
the wheel is configured to be separable into a plurality of parts and configured to be detachable from the chair.

7. The wheelchair simulator according to any one of claims 1 to 3, wherein
the control unit includes
a center-of-gravity measurement unit that measures a center of gravity of the seat, and
the display controller causes the display unit to display the center of gravity on the seat measured by the center-of-gravity measurement unit.

8. The wheelchair simulator according to claim 7, comprising
a base configured to support an entire wheelchair,
the base includes
a load sensor configured to detect a load applied to the base, and
the center-of-gravity measurement unit measures the center of gravity on the seat based on the load applied to the base detected by the load sensor.
